# EUROPEAN PATENT APPLICATION

(11) **EP 4 195 245 A1**
(43) Date of publication of application: **14.06.2023**
(21) Application number: 22206544.3
(22) Date of filing: 10.11.2022
(51) Int. Cl.: H01L 21/768, H01L 23/367, H01L 23/48, H01L 23/528, H01L 23/535, H01L 27/02

(54) **BACKSIDE HEAT DISSIPATION USING BURIED HEAT RAILS**

(30) Priority: 13.12.2021 US 202117549137
(71) Applicant: INTEL Corporation, Santa Clara, CA 95054 (US)
(72) Inventor: GEIGER, Richard, 80939 Muenchen (DE); PANAGOPOULOS, Georgios, 80539 Munich (DE); RAUH, Johannes, 85614 Kirchseeon (DE); GOSSNER, Harald, 85521 Riemerling (DE)
(74) Representative: HGF

(57) **Abstract**

IC devices including BHRs and TSVs for backside heat dissipation are disclosed. An example IC device includes semiconductor structures. The IC device also includes an electrically conductive layer coupled to the semiconductor structures. The IC device further includes one or more BHRs coupled to the electrically conductive layer. Each BHR is connected to a heat dissipation plate by a TSV buried in a support structure. The heat dissipation plate is at the backside of the support structure. The BHRs, TSVs, and heat dissipation plate can conduct heat generated by the semiconductor structures to the backside of the support structure. The BHRs may also be used as power rails for delivering power to the semiconductor structures. A TSV can be enlarged to have a larger cross-sectional area than the BHR for enhancing the heat dissipation. Also, the heat dissipation plate may exceed a cell boundary for sinking heat more efficiently.

## Description

### Technical Field

This disclosure relates generally to the field of semiconductor devices, and more specifically, to integrated circuit (IC) devices.

### Background

A field-effect transistor (FET), e.g., a metal-oxide-semiconductor (MOS) FET (MOSFET), is a three-terminal device that includes source, drain, and gate terminals and uses electric field to control current flowing through the device. A FET typically includes a semiconductor channel material, a source and a drain regions provided in the channel material, and a gate stack (also referred to as "gate") that includes at least a gate electrode material and may also include a gate dielectric material, the gate stack provided over a portion of the channel material between the source and the drain regions. Because gate electrode materials often include metals, gates of transistors are commonly referred to as "metal gates."

Recently, FETs with non-planar architectures, such as FinFETs (also sometimes referred to as "wrap around gate transistors" or "tri-gate transistors") and nanosheet or nanoribbon FET (also sometimes referred to as "all-around gate transistors"), have been extensively explored as alternatives to transistors with planar architectures.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 is a perspective view of an example FinFET, according to some embodiments of the disclosure.
FIG. 2 is a perspective view of an example IC device including BPRs for power delivery and backside heat dissipation, according to some embodiments of the disclosure.
FIG. 3 is a top view of an example IC device including a plurality of cells, according to some embodiments of the disclosure.
FIG. 4 is a cross-sectional view of an example IC device including buried heat rails (BHRs) and through-substrate vias (TSVs) for heat dissipation, according to some embodiments of the disclosure.
FIG. 5 is a cross-sectional view of an example IC device including BHRs and enlarged TSVs for heat dissipation, according to some embodiments of the disclosure.
FIG. 6 is a top view of an example IC device including filler cells used for heat dissipation, according to some embodiments of the disclosure.
FIG. 7 is a cross-sectional view of an example IC device including an exceeding heat dissipation plate, according to some embodiments of the disclosure.
FIG. 8 is a top view of an example IC device including exceeding heat dissipation plates, according to some embodiments of the disclosure.
FIGS. 9A-9B are top views of a wafer and dies that may include one or more BHRs, according to some embodiments of the disclosure.
FIG. 10 is a side, cross-sectional view of an example IC package that may include one or more IC devices having one or more BHRs, according to some embodiments of the disclosure.
FIG. 11 is a cross-sectional side view of an IC device assembly that may include components having one or more BHRs, according to some embodiments of the disclosure.
FIG. 12 is a block diagram of an example computing device that may include one or more components with one or more BHRs, according to some embodiments of the disclosure.

### Detailed Description

### Overview

The systems, methods, and devices of this disclosure each have several innovative aspects, no single one of which is solely responsible for all of the desirable attributes disclosed herein. Details of one or more implementations of the subject matter described in this specification are set forth in the description below and the accompanying drawings.

For purposes of illustrating IC devices with backside heat dissipation using BHRs, proposed herein, it might be useful to first understand phenomena that may come into play in such structures. The following foundational information may be viewed as a basis from which the present disclosure may be properly explained. Such information is offered for purposes of explanation only and, accordingly, should not be construed in any way to limit the broad scope of the present disclosure and its potential applications. While some of the following descriptions may be provided for the example of transistors being implemented as FinFETs, nanoribbon FETs, or nanosheet FETs, embodiments of the present disclosure are equally applicable to IC devices employing transistors of other architectures, such as nanoribbon or nanowire transistors, as well as to planar transistors.

For the past several decades, the scaling of features in ICs has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for the ever-increasing capacity, however, is not without issue. The necessity to optimize the performance of each device becomes increasingly significant and such optimization is far from trivial.

Relentless scaling of transistors and wires in advanced semiconductor technologies has not only resulted in major process-related challenges but has also imposed severe design challenges in the sub-5nm technology regime. Dimensional scaling of designs has been made possible by (i) Front-End-of-Line (FEOL) and Back-End-of-Line (BEOL) pitch scaling, which worsens short-channel effects in transistors and increases wire/contact resistances; and, (ii) fin depopulation in logic cells, which causes degradation of transistor drive. To enable further area scaling in sub-5nm nodes, an approach of burying the power rails into the substrate has been proposed, which no longer requires reserving two routing tracks for power nets (e.g., VDD or VSS) in the logic cell area. Additionally, these BPRs can achieve a higher aspect ratio, thus, exhibiting lower resistance than local level BEOL power rails. BPRs can be a key scaling booster for complementary metal-oxide-semiconductor (CMOS) extension beyond the 5-nm node. Power lines which conventionally run outside substrates can be replaced with power lines "buried" within substrates, such as shallow trench isolation (STI) and Si substrate. Such power lines are called BPRs. A BPR is a power rail that is at least partially buried in a support structure, e.g., a substrate, die, etc. A BPR includes an electrically conductive material, such as metal. A rail can have an elongated structure having a longitudinal axis, which may be parallel to the frontside surface or the backside surface of the support structure. BPR frees up routing resources, which results in logic cell height reduction and overall area scaling.

In IC devices including transistors (e.g., FinFETs, nanoriboon FETs, nanowire FETs,, etc.), the transistors are susceptible to heat. For example, during a 1 - 100 ns ESD discharge into the I/O circuit the transistors experience a very high current density in the order of 10 mA/µm (effective transistor width). Due to the density of the downscaled IC technologies, this leads to an extreme local heat dissipation, which can lead to thermal damage of the transistors. In a planar bulk CMOS technology, heat is usually conducted into the substrate, which helps to mitigate the self-heating problem. This extends into a range of 3 µm. In FinFET technology and even more enhanced in gate all around technology (GAA), the heat dissipation into the substrate is strongly limited by the small contact region of fin or GAA S/D region to the bulk of the silicon substrate. Some FinFET/GAA technologies conducts heat to the frontside metal layers. However, the heat conduction into the frontside metal layers also suffers from downscaling as the via cross-section becomes smaller and the metal layers become thinner. Together this reduces the effectiveness of heat diffusion to the higher layers of the frontside metal layers. Therefore, alternative paths for the heat flow have to be established.

The present invention relates to IC devices including BHRs for backside heat dissipation. An example IC device includes semiconductor structures of one or more transistors, a BHR thermally coupled to the semiconductor structures, a heat dissipation plate, and a TSV connecting the BHRs to the heat dissipation plate. The semiconductor structures are structures (e.g., fins, nanoribbon, nanowire, etc.) of one or more semiconductor materials. The transistors may be NMOS (N-type metal-oxide-semiconductor) transistors or PMOS (P-type metal-oxide-semiconductor) transistors. A transistor may be over or at least partially in a support structure of the IC device. The transistor is closer to the frontside surface of the support structure than the backside surface of the support structure. In some embodiments, the semiconductor structures are in the support structure, e.g., at the frontside of the semiconductor structure. The support structure includes a semiconductor material, such as the semiconductor material of the semiconductor structures.

The BHR is a rail that includes a thermally conductive material and is buried in the support structure. The BHR may be made of metal or other types of thermally conductive materials. The support structure may include an insulator layer, which encloses a portion of each semiconductor structure and a semiconductor layer adjoining the insulator layer. A portion of the BHR is buried in the insulator layer and the remaining portion is buried in the semiconductor layer. The BHR is thermally coupled to the semiconductor structures. For instance, the BHR is coupled to an electrically conductive layer, e.g., by vias, that is connected to the semiconductor structures to provide power to the semiconductor structures. In some embodiments, the BHR may also be electrically coupled to the semiconductor structures for delivery of power to the semiconductor structures. The BHR, in these embodiments, is also a buried power rail (BPR). A BPR is a a rail that includes an electrically conductive material and is buried in the support structure. The BPR is coupled to a power or ground plane to deliver power to the semiconductor structures. In these embodiments, the BHR may include a material that is both electrically and thermally conductive.

The BHR is also connected to the TSV. The TSV is a via at least partially in the support structure. The TSV may extend between the frontside surface of the support structure to the backside surface of the support structure. For instance, the TSV extends from a surface of the BHR, which is in contact with the TSV, to the backside surface of the support structure. The TSV couples the BHR to the heat dissipation plate. The heat dissipation plate is a plate including a thermally conductive material for dissipating heat. The heat dissipation plate is outside the support structure. In an example, the heat dissipation plate adjoins the backside of the support structure. The backside of the support structure is a surface of the support structure opposing the surface of the support structure where the semiconductor structures are located. As the TSV couples the BHR to the heat dissipation plate, the BHR, TSV, and heat dissipation plate form a heat dissipation path that delivers heat from the semiconductor structures to the backside of the support structure.

The IC device may include multiple BHRs and TSVs connected to the heat dissipation plate. Each pair of BHR and TSV can be coupled to one semiconductor structure, one stack of semiconductor structure, or one transistor for dissipating heat from the semiconductor structure, stack of semiconductor structures, or transistor. In some embodiments, a TSV is enlarged. For example, the surface of the TSV contacting with the BHR has a larger cross-sectional area than the BHR. Additionally or alternatively, the heat dissipation plate may exceed a side of the support structure. For instance, a length of the heat dissipation plate is larger than a length of the support structure from a power plane of the IC device to a ground plane of the IC device. The enlarged TSV or exceeding heat dissipation plate can enhance the heat dissipation efficiency.

By using the BHR and TSV, the present invention provides a heat dissipation path from the transistors to the backside of IC device. The backside heat dissipation mechanism overcomes the disadvantages of heat conduction to substate or frontside metal layers that are described above. Also, as the BHR and TSV are close to the semiconductor structures, the backside heat dissipation mechanism can sink heat efficiently. Moreover, as the BHR can be used as a power rail to deliver power to the semiconductor structures, the present invention can further improve space efficiency in the support structure.

Elongated structures are mentioned throughout the present description. As used herein, a structure is referred to as an elongated if a length of the structure (measured alone one axis of an example coordinate system) is greater than both a width of the structure (measured alone another axis of the example coordinate system) and a height of the structure (measured alone a third axis of the example coordinate system). For example, elongated semiconductor structures as described herein may be fins or nanoribbons, having a length measured along an x-axis of the coordinate system shown in the present drawings, a width measured along a y axis of the coordinate system shown in the present drawings, and a height measured along a z-axis of the coordinate system shown in the present drawings. Because BHRs described herein, as well as openings above them, are substantially parallel to the semiconductor structures, their lengths, widths, and heights are also measured along, respectively, an x-axis, a y axis, and a z-axis of the x-y-z coordinate system shown in the present drawings. On the other hand, when the metal gate lines are substantially perpendicular to the semiconductor structures, as shown in the embodiments of the present drawings, their lengths, widths, and heights are measured along, respectively, a y axis, an x-axis, and a z-axis of the x-y-z coordinate system shown.

While some of the descriptions provided herein refer to FinFETs, these descriptions are equally applicable to embodiments any other non-planar FETs besides FinFETs, e.g., to nanoribbon transistors, nanowire transistors, or transistors such as nanoribbon/nanowire transistors but having transverse cross-sections of any geometry (e.g., oval, or a polygon with rounded corners).

IC devices as described herein, in particular IC devices with backside heat dissipation using BHRs as described herein, may be used for providing electrical connectivity to one or more components associated with an IC or/and between various such components. In various embodiments, components associated with an IC include, for example, transistors, diodes, power sources, resistors, capacitors, inductors, sensors, transceivers, receivers, antennas, etc. Components associated with an IC may include those that are mounted on IC or those connected to an IC. The IC may be either analog or digital and may be used in a number of applications, such as microprocessors, optoelectronics, logic blocks, audio amplifiers, etc., depending on the components associated with the IC. The IC may be employed as part of a chipset for executing one or more related functions in a computer.

For purposes of explanation, specific numbers, materials, and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well-known features are omitted or simplified in order not to obscure the illustrative implementations.

Further, references are made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense. For convenience, if a collection of drawings designated with different letters are present, such a collection may be referred to herein without the letters.

In the drawings, some schematic illustrations of example structures of various devices and assemblies described herein may be shown with precise right angles and straight lines, this is simply for ease of illustration, and embodiments of these assemblies may be curved, rounded, or otherwise irregularly shaped as dictated by, and sometimes inevitable due to, the manufacturing processes used to fabricate semiconductor device assemblies. Therefore, it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Furthermore, although a certain number of a given element may be illustrated in some of the drawings (e.g., a certain number of channels, a certain number of electrically conductive layers, a certain number of BHRs, a certain number of vias, a certain number of TSVs, a certain number of heat dissipation plates, a certain number of cells, etc.), this is simply for ease of illustration, and more, or less, than that number may be included in an IC device with at least one BHR as described herein. Still further, various views shown in some of the drawings are intended to show relative arrangements of various elements therein. In other embodiments, various IC devices with BHRs as described herein, or portions thereof, may include other elements or components that are not illustrated (e.g., transistor portions, various components that may be in electrical contact with any of the transistors, etc.). Inspection of layout and mask data and reverse engineering of parts of a device to reconstruct the circuit using e.g., optical microscopy, TEM, or SEM, and/or inspection of a cross-section of a device to detect the shape and the location of various device elements described herein using e.g., Physical Failure Analysis (PFA) would allow determination of presence of IC devices with BHRs as described herein.

Various operations may be described as multiple discrete actions or operations in turn, in a manner that is most helpful in understanding the claimed subject matter. However, the order of description should not be construed as to imply that these operations are necessarily order dependent. These operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges.

The description uses the phrases "in an embodiment" or "in embodiments," which may each refer to one or more of the same or different embodiments. The terms "comprising," "including," "having," and the like, as used with respect to embodiments of the present disclosure, are synonymous. The disclosure may use perspective-based descriptions such as "above," "below," "top," "bottom," and "side" to explain various features of the drawings, but these terms are simply for ease of discussion, and do not imply a desired or required orientation. The accompanying drawings are not necessarily drawn to scale. Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner.

In the following detailed description, various aspects of the illustrative implementations will be described using terms commonly employed by those skilled in the art to convey the substance of their work to others skilled in the art.

For example, some descriptions may refer to a particular source or drain region or contact being either a source region/contact or a drain region/contact. However, unless specified otherwise, which region/contact of a transistor is considered to be a source region/contact and which region/contact is considered to be a drain region/contact is not important because under certain operating conditions, designations of source and drain are often interchangeable. Therefore, descriptions provided herein may use the term of a "S/D" region/contact to indicate that the region/contact can be either a source region/contact, or a drain region/contact.

In another example, if used, the terms "package" and "IC package" are synonymous, as are the terms "die" and "IC die," the term "insulating" means "electrically insulating," the term "conducting" means "electrically conducting," unless otherwise specified. Although certain elements may be referred to in the singular herein, such elements may include multiple sub-elements. For example, "an electrically conductive material" may include one or more electrically conductive materials.

In another example, if used, the terms "oxide," "carbide," "nitride," etc. refer to compounds containing, respectively, oxygen, carbon, nitrogen, etc., the term "high-k dielectric" refers to a material having a higher dielectric constant than silicon oxide, while the term "low-k dielectric" refers to a material having a lower dielectric constant than silicon oxide.

In yet another example, a term "interconnect" may be used to describe any element formed of an electrically conductive material for providing electrical connectivity to one or more components associated with an IC or/and between various such components. In general, the "interconnect" may refer to both conductive lines/wires (also sometimes referred to as "lines" or "metal lines" or "trenches") and conductive vias (also sometimes referred to as "vias" or "metal vias"). In general, a term "conductive line" may be used to describe an electrically conductive element isolated by a dielectric material typically comprising an interlayer low-k dielectric that is provided within the plane of an IC chip. Such conductive lines are typically arranged in several levels, or several layers, of metallization stacks. On the other hand, the term "conductive via" may be used to describe an electrically conductive element that interconnects two or more conductive lines of different levels of a metallization stack. To that end, a via may be provided substantially perpendicularly to the plane of an IC chip or a support structure over which an IC device is provided and may interconnect two conductive lines in adjacent levels or two conductive lines in not adjacent levels. A term "metallization stack" may be used to refer to a stack of one or more interconnects for providing connectivity to different circuit components of an IC chip.

Furthermore, the term "connected" may be used to describe a direct electrical or magnetic connection between the things that are connected, without any intermediary devices, while the term "coupled" may be used to describe either a direct electrical or magnetic connection between the things that are connected, or an indirect connection through one or more passive or active intermediary devices. The term "circuit" may be used to describe one or more passive and/or active components that are arranged to cooperate with one another to provide a desired function.

The terms "substantially," "close," "approximately," "near," and "about," generally refer to being within +/- 20% of a target value based on the context of a particular value as described herein or as known in the art. Similarly, terms indicating orientation of various elements, e.g., "coplanar," "perpendicular," "orthogonal," "parallel," or any other angle between the elements, generally refer to being within +/- 5-20% of a target value based on the context of a particular value as described herein or as known in the art.

### Example FET

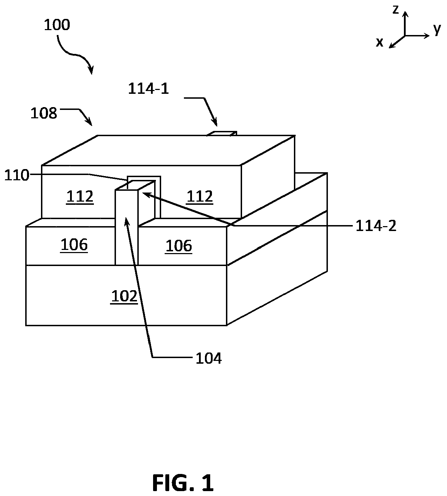

FIG. 1 is a perspective view of an example FinFET 100, according to some embodiments of the disclosure. The FinFET 100 illustrates one example of a transistor that can be coupled to BPRs. The FinFET 100 shown in FIG. 1 is intended to show relative arrangement(s) of some of the components therein. In various embodiments, the FinFET 100, or portions thereof, may include other components that are not illustrated (e.g., any further materials, such as spacer materials, surrounding the gate stack of the FinFET 100, electrical contacts to the S/D regions of the FinFET 100, etc.).

As shown in FIG. 1, the FinFET 100 may be provided over a support structure 102, where the support structure 102 may be any suitable support structure on which a transistor may be built, e.g., a substrate, a die, a wafer, or a chip. As also shown in FIG. 1, the FinFET 100 may include a fin 104, extending away from the support structure 102. A portion of the fin 104 that is closest to the support structure 102 may be enclosed by an insulator material 106, commonly referred to as an "STI material" or, simply, "STI." The portion of the fin 104 enclosed on its' sides by the STI 106 is typically referred to as a "subfin portion" or simply a "subfin." As further shown in FIG. 1, a gate stack 108 that includes at least a layer of a gate electrode material 112 and, optionally, a layer of a gate dielectric 110, may be provided over the top and sides of the remaining upper portion of the fin 104 (e.g., the portion above and not enclosed by the STI 106), thus wrapping around the upper-most portion of the fin 104. The portion of the fin 104 over which the gate stack 108 wraps around may be referred to as a "channel portion" of the fin 104 because this is where, during operation of the FinFET 100, a conductive channel may form. The channel portion of the fin 104 is a part of an active region of the fin 104. A first S/D region 114-1 and a second S/D region 114-2 (also commonly referred to as "diffusion regions") are provided on the opposite sides of the gate stack 108, forming source and drain terminals of the FinFET 100.

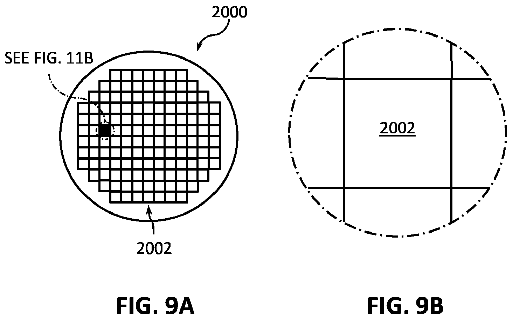

In general, implementations of the present disclosure may be formed or carried out on a support structure such as a semiconductor substrate, composed of semiconductor material systems including, for example, n-type or p-type materials systems. In one implementation, the semiconductor substrate may be a crystalline substrate formed using a bulk silicon or a silicon-on-insulator substructure. In other implementations, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V, group II-VI, or group IV materials. In some embodiments, the substrate may be non-crystalline. In some embodiments, the support structure 102 may be a printed circuit board (PCB) substrate. Although a few examples of materials from which the substrate may be formed are described here, any material that may serve as a foundation upon which IC devices implementing backside heat dissipation using BHRs as described herein may be built falls within the scope of the present disclosure. In various embodiments, the support structure 102 may include any such substrate material that provides a suitable surface for forming the FinFET 100. The support structure 102 may, e.g., be the wafer 2000 of FIG. 9A, discussed below, and may be, or be included in, a die, e.g., the singulated die 2002 of FIG. 9B, discussed below.

As shown in FIG. 1, the fin 104 may extend away from the support structure 102 and may be substantially perpendicular to the support structure 102. The fin 104 may include one or more semiconductor materials, e.g., a stack of semiconductor materials, so that the upper-most portion of the fin (namely, the portion of the fin 104 enclosed by the gate stack 108) may serve as the channel region of the FinFET 100. Therefore, as used herein, the term "channel material" of a transistor may refer to such upper-most portion of the fin 104, or, more generally, to any portion of one or more semiconductor materials in which a conductive channel between source and drain regions may be formed during operation of a transistor.

As shown in FIG. 1, the STI material 106 may enclose the sides of the fin 104. A portion of the fin 104 enclosed by the STI 106 forms a subfin. In various embodiments, the STI material 106 may be a low-k or high-k dielectric including, but not limited to, elements such as hafnium, silicon, oxygen, nitrogen, titanium, tantalum, lanthanum, aluminum, zirconium, barium, strontium, yttrium, lead, scandium, niobium, and zinc. Further examples of dielectric materials that may be used in the STI material 106 may include, but are not limited to silicon nitride, silicon oxide, silicon dioxide, silicon carbide, silicon nitride doped with carbon, silicon oxynitride, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate.

Above the subfin portion of the fin 104, the gate stack 108 may wrap around the fin 104 as shown in FIG. 1. In particular, the gate dielectric 110 may wrap around the upper-most portion of the fin 104, and the gate electrode 112 may wrap around the gate dielectric 110. The interface between the channel portion of the fin 104 and the subfin portion of the fin 104 is located proximate to where the gate electrode 112 ends.

The gate electrode 112 may include one or more gate electrode materials, where the choice of the gate electrode materials may depend on whether the FinFET 100 is a p-type metal-oxide-semiconductor (PMOS) transistor or an n-type metal-oxide-semiconductor (NMOS) transistor. For a PMOS transistor, gate electrode materials that may be used in different portions of the gate electrode 112 may include, but are not limited to, ruthenium, palladium, platinum, cobalt, nickel, and conductive metal oxides (e.g., ruthenium oxide). For an NMOS transistor, gate electrode materials that may be used in different portions of the gate electrode 112 include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). In some embodiments, the gate electrode 112 may include a stack of a plurality of gate electrode materials, where zero or more materials of the stack are workfunction (WF) materials and at least one material of the stack is a fill metal layer. Further materials/layers may be included next to the gate electrode 112 for other purposes, such as to act as a diffusion barrier layer or/and an adhesion layer.

If used, the gate dielectric 110 may include a stack of one or more gate dielectric materials. In some embodiments, the gate dielectric 110 may include one or more high-k dielectric materials. In various embodiments, the high-k dielectric materials of the gate dielectric 110 may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric 110 may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In some embodiments, an annealing process may be carried out on the gate dielectric 110 during manufacture of the FinFET 100 to improve the quality of the gate dielectric 110.

In some embodiments, the gate stack 108 may be surrounded by a dielectric spacer, not specifically shown in FIG. 1. The dielectric spacer may be configured to provide separation between the gate stacks 108 of different FinFETs 100 which may be provided along a single fin (e.g., different FinFETs provided along the fin 104, although FIG. 1 only illustrates one of such FinFETs), as well as between the gate stack 108 and the source/drain contacts disposed on each side of the gate stack 108. Such a dielectric spacer may include one or more low-k dielectric materials. Examples of the low-k dielectric materials that may be used as the dielectric spacer include, but are not limited to, silicon dioxide, carbon-doped oxide, silicon nitride, fused silica glass (FSG), and organosilicates such as silsesquioxane, siloxane, and organosilicate glass. Other examples of low-k dielectric materials that may be used as the dielectric spacer include organic polymers such as polyimide, polynorbornenes, benzocyclobutene, perfluorocyclobutane, or polytetrafluoroethylene (PTFE). Still other examples of low-k dielectric materials that may be used as the dielectric spacer include silicon-based polymeric dielectrics such as hydrogen silsesquioxane (HSQ) and methylsilsesquioxane (MSQ). Other examples of low-k materials that may be used in a dielectric spacer include various porous dielectric materials, such as for example porous silicon dioxide or porous carbon-doped silicon dioxide, where large voids or pores are created in a dielectric in order to reduce the overall dielectric constant of the layer, since voids can have a dielectric constant of nearly 1. When such a dielectric spacer is used, then the lower portions of the fin 104, e.g., the subfin portion of the fin 104, may be surrounded by the STI material 106 which may, e.g., include any of the high-k dielectric materials described herein.

In some embodiments, the fin 104 may be composed of semiconductor material systems including, for example, n-type or p-type materials systems. In some embodiments, the fin 104 may include a high mobility oxide semiconductor material, such as tin oxide, antimony oxide, indium oxide, indium tin oxide, titanium oxide, zinc oxide, indium zinc oxide, gallium oxide, titanium oxynitride, ruthenium oxide, or tungsten oxide. In some embodiments, the fin 104 may include a combination of semiconductor materials where one semiconductor material is used for the channel portion and another material, sometimes referred to as a "blocking material," is used for at least a portion of the subfin portion of the fin 104. In some embodiments, the subfin and the channel portions of the fin 104 are each formed of monocrystalline semiconductors, such as silicon or germanium. In a first embodiment, the subfin and the channel portion of the fin 104 are each formed of compound semiconductors with a first sub-lattice of at least one element from group III of the periodic table (e.g., Al, Ga, In), and a second sub-lattice of at least one element of group V of the periodic table (e.g., P, As, Sb). The subfin may be a binary, ternary, or quaternary III-V compound semiconductor that is an alloy of two, three, or even four elements from groups III and V of the periodic table, including boron, aluminum, indium, gallium, nitrogen, arsenic, phosphorus, antimony, and bismuth.

For some example n-type transistor embodiments (i.e., for the embodiments where the FinFET 100 is an NMOS), the channel portion of the fin 104 may advantageously include a III-V material having a high electron mobility, such as, but not limited to InGaAs, InP, InSb, and InAs. For some such embodiments, the channel portion of the fin 104 may be a ternary III-V alloy, such as InGaAs, GaAsSb, InAsP, or InPSb. For some InₓGa₁₋ₓAs fin embodiments, In content (x) may be between 0.6 and 0.9, and may advantageously be at least 0.7 (e.g., In_{0.7}Ga_{0.3}As). In some embodiments with highest mobility, the channel portion of the fin 104 may be an intrinsic III-V material, i.e., a III-V semiconductor material not intentionally doped with any electrically active impurity. In alternate embodiments, a nominal impurity dopant level may be present within the channel portion of the fin 104, for example to further fine-tune a threshold voltage Vt, or to provide HALO pocket implants, etc. Even for impurity-doped embodiments however, impurity dopant level within the channel portion of the fin 104 may be relatively low, for example below 10¹⁵ dopant atoms per cubic centimeter (cm⁻³), and advantageously below 10¹³ cm⁻³. The subfin portion of the fin 104 may be a III-V material having a band offset (e.g., conduction band offset for n-type devices) from the channel portion. Example materials include, but are not limited to, GaAs, GaSb, GaAsSb, GaP, InAIAs, GaAsSb, AlAs, AIP, AlSb, and AIGaAs. In some n-type transistor embodiments of the FinFET 100 where the channel portion of the fin 104 is InGaAs, the subfin may be GaAs, and at least a portion of the subfin may also be doped with impurities (e.g., p-type) to a greater impurity level than the channel portion. In an alternate heterojunction embodiment, the subfin and the channel portion of the fin 104 are each, or include, group IV semiconductors (e.g., Si, Ge, SiGe). The subfin of the fin 104 may be a first elemental semiconductor (e.g., Si or Ge) or a first SiGe alloy (e.g., having a wide bandgap).

For some example p-type transistor embodiments (i.e., for the embodiments where the FinFET 100 is a PMOS), the channel portion of the fin 104 may advantageously be a group IV material having a high hole mobility, such as, but not limited to Ge or a Ge-rich SiGe alloy. For some example embodiments, the channel portion of the fin 104 may have a Ge content between 0.6 and 0.9, and advantageously may be at least 0.7. In some embodiments with highest mobility, the channel portion may be intrinsic III-V (or IV for p-type devices) material and not intentionally doped with any electrically active impurity. In alternate embodiments, one or more a nominal impurity dopant level may be present within the channel portion of the fin 104, for example to further set a threshold voltage Vt, or to provide HALO pocket implants, etc. Even for impurity-doped embodiments however, impurity dopant level within the channel portion is relatively low, for example below 10¹⁵ cm⁻³, and advantageously below 10¹³ cm⁻³. The subfin of the fin 104 may be a group IV material having a band offset (e.g., valance band offset for p-type devices) from the channel portion. Example materials include, but are not limited to, Si or Si-rich SiGe. In some p-type transistor embodiments, the subfin of the fin 104 is Si and at least a portion of the subfin may also be doped with impurities (e.g., n-type) to a higher impurity level than the channel portion.

Turning to the first S/D region 114-1 and the second S/D region 114-2 on respective different sides of the gate stack 108, in some embodiments, the first S/D region 114-1 may be a source region and the second S/D region 114-2 may be a drain region. In other embodiments this designation of source and drain may be interchanged, i.e., the first S/D region 114-1 may be a drain region and the second S/D region 114-2 may be a source region. Although not specifically shown in FIG. 1, the FinFET 100 may further include S/D electrodes (also commonly referred to as "S/D contacts"), formed of one or more electrically conductive materials, for providing electrical connectivity to the S/D regions 114, respectively. In some embodiments, the S/D regions 114 of the FinFET 100 may be regions of doped semiconductors, e.g., regions of doped channel material of the fin 104, so as to supply charge carriers for the transistor channel. In some embodiments, the S/D regions 114 may be highly doped, e.g., with dopant concentrations of about 1·10²¹ cm⁻³, in order to advantageously form Ohmic contacts with the respective S/D electrodes, although these regions may also have lower dopant concentrations and may form Schottky contacts in some implementations. Irrespective of the exact doping levels, the S/D regions 114 of the FinFET 100 are the regions having dopant concentration higher than in other regions, e.g., higher than a dopant concentration in a region of the semiconductor channel material between the first S/D region 114-1 and the second S/D region 114-2, and, therefore, may be referred to as "highly doped" (HD) regions.

In some embodiments, the S/D regions 114 may generally be formed using either an implantation/diffusion process or an etching/deposition process. In the former process, dopants such as boron, aluminum, antimony, phosphorous, or arsenic may be ion-implanted into the one or more semiconductor materials of the upper portion of the fin 104 to form the S/D regions 114. An annealing process that activates the dopants and causes them to diffuse further into the fin 104 may follow the ion implantation process. In the latter process, the one or more semiconductor materials of the fin 104 may first be etched to form recesses at the locations for the future source and drain regions. An epitaxial deposition process may then be carried out to fill the recesses with material (which may include a combination of different materials) that is used to fabricate the S/D regions 114. In some implementations, the S/D regions 114 may be fabricated using a silicon alloy such as silicon germanium or silicon carbide. In some implementations, the epitaxially deposited silicon alloy may be doped in situ with dopants such as boron, arsenic, or phosphorous. In further embodiments, the S/D regions 114 may be formed using one or more alternate semiconductor materials such as germanium or a group III-V material or alloy. Although not specifically shown in the perspective illustration of FIG. 1, in further embodiments, one or more layers of metal and/or metal alloys may be used to form the source and drain contacts (i.e., electrical contacts to each of the S/D regions 114).

The FinFET 100 may have a gate length, GL, (i.e., a distance between the first S/D region 114-1 and the second S/D region 114-2), a dimension measured along the longitudinal axis of the fin 104, which extends in the direction of the x-axis of the example reference coordinate system x-y-z shown in the present drawings, where the gate length may, in some embodiments, be between about 5 and 40 nanometers, including all values and ranges therein (e.g. between about 22 and 35 nanometers, or between about 15 and 25 nanometers). The fin 104 may have a thickness, a dimension measured in the direction of the y-axis of the reference coordinate system x-y-z shown in FIG. 1, that may, in some embodiments, be between about 4 and 15 nanometers, including all values and ranges therein (e.g., between about 5 and 10 nanometers, or between about 7 and 12 nanometers). The fin 104 may have a height, a dimension measured in the direction of the z-axis of the reference coordinate system x-y-z shown in FIG. 1, which may, in some embodiments, be between about 30 and 350 nanometers, including all values and ranges therein (e.g., between about 30 and 200 nanometers, between about 75 and 250 nanometers, or between about 150 and 300 nanometers).

Although the fin 104 is illustrated in FIG. 1 as having a rectangular cross-section in a z-y plane of the reference coordinate system shown in FIG. 1, the fin 104 may instead have a cross-section that is rounded or sloped at the "top" of the fin 104, and the gate stack 108 (including the different portions of the gate dielectric 110) may conform to this rounded or sloped fin 104. In use, the FinFET 100 may form conducting channels on three "sides" of the channel portion of the fin 104, potentially improving performance relative to single-gate transistors (which may form conducting channels on one "side" of a channel material or substrate) and double-gate transistors (which may form conducting channels on two "sides" of a channel material or substrate). While FIG. 1 illustrates a single FinFET 100, in some embodiments, a plurality of FinFETs may be arranged next to one another (with some spacing in between) along the fin 104.

Other types of semiconductor structures can be used in a FET. For example, nanoribbon-based FETs include elongated semiconductor structures called nanoribbons as semiconductor structures. As another example, nanowire-based FETs include nanowires as semiconductor structures. As used herein, the term "nanoribbon" refers to an elongated semiconductor structure having a longitudinal axis parallel to the support structure over which a memory device is provided. Typically, a length of a such a structure (i.e., a dimension measured along the longitudinal axis, shown in the present drawings to be along the y-axis of an example x-y-z coordinate system) is greater than each of a width (i.e., a dimension measured along the x-axis of the example coordinate system shown in the present drawings) and a thickness/height (i.e., a dimension measured along the z-axis of the example coordinate system shown in the present drawings). In some settings, the terms "nanoribbon" or "nanosheet" have been used to describe elongated semiconductor structures that have a rectangular transverse cross-section (i.e., a cross-section in a plane perpendicular to the longitudinal axis of the structure), while the term "nanowire" has been used to describe similar elongated structures but with circular transverse cross-sections.

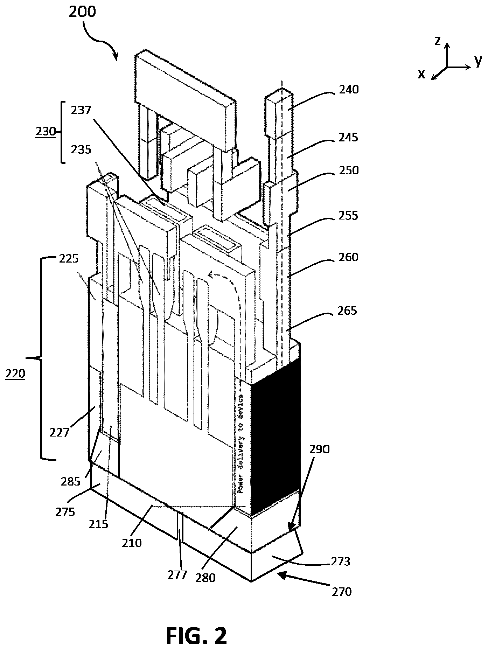

FIG. 2 is a perspective view of an example IC device 200 including BPRs 210 and 215 for power delivery and backside heat dissipation, according to some embodiments of the disclosure. The IC device 200 includes a support structure 220 where the BPRs 210 and 215 are buried, transistors 230 (individually referred to as "transistor 230"), electrically conductive layers 240, 250, and 260, vias 245, 255, and 265, a heat dissipation plate 270, and TSVs 280 and 285. In other embodiments, the IC device 200 may include more, fewer, or different components. In some embodiments, the components of the IC device 200 may be arranged differently. For instance, the electrically conductive layer 240 may be arranged below the support structure 220 for backside power delivery.

A transistor 230 includes semiconductor structures 235 (individually referred to as "semiconductor structure 235") and a gate 237. A semiconductor structure 235 may be a fin, nanoribbon, or nanowire of a semiconductor material. In some embodiments, at least a portion of a semiconductor structure 235 are formed in the support structure 220. The gate 237 has a first portion at least partially wrapping around a portion of a semiconductor structure 235 on a source region of the transistor 230. The gate 237 also has a second portion at least partially wrapping around a portion of another semiconductor structure 235 on a drain region of the transistor 230. An embodiment of the gate 237 is the gate stack 108 in FIGS. 1-3. A transistor 230 may be a NMOS or PMOS transistor.

The support structure 220 includes a semiconductor layer 225 and an insulator layer 227. A portion of each BPR 210 or 215 is buried in the semiconductor layer 225, and the remaining portion of the BPR 210 or 215 is buried in the insulator layer 227. The semiconductor layer 225 includes a semiconductor material. Examples of the semiconductor material include, for example, single crystal silicon, polycrystalline silicon, silicon-on-insulator (SOI), other suitable semiconductor material, or some combination thereof. The semiconductor layer 225 may also include other materials, such as metal, dielectric, dopant, and so on. In FIG. 2, the semiconductor layer 225 has a top surface and a bottom surface. The top surface of the semiconductor layer 225 contacts with the bottom surface of the insulator layer 227. The bottom surface of the semiconductor layer 225 is the bottom surface of the IC device 200 and can be referred to as the backside of the IC device 200. In some embodiments, the semiconductor layer 225, or a portion of it, is dopped to generate a p-type support structure or N-type support structure.

The insulator layer 227 functions as an electrical insulator that isolates conducting and semiconducting materials from each other. In some embodiments, the insulator layer 227 is an oxide layer. An example oxide layer is a layer of silicon oxide, SiOₓ, where x is an integer number, such as 2, 2, etc. The insulator layer 227 adjoins the semiconductor layer 225. As shown in FIG. 2, the insulator layer 227 is above the semiconductor layer 225. In some embodiments, the insulator layer 427 is not a continuous insulator layer. Rather, the insulator layer 227 includes discrete insulator sections arranged in the semiconductor material of the semiconductor layer 225. The discrete insulator sections can insulate BPRs from the semiconductor material. The discrete insulator sections can also insulate semiconductor structures, which are formed in the semiconductor layer 225, of transistors from each other. The discrete insulator sections may include an oxide of the semiconductor material and can be formed from portions of the semiconductor layer 225.

In some embodiments, the insulator layer 227 may be formed by transforming a portion of a silicon support structure into silicon oxide. Silicon exposed to ambient conditions has a native oxide on its surface. The native oxide is approximately 3 nm thick at room temperature. However, 3 nm may be too thin for most applications and a thicker insulator layer needs to be grown. This is done by consuming the underlying Si to form SiOx. This is a grown layer. It is also possible to grow SiOx by a chemical vapor deposition process using Si and O precursor molecules. In this embodiment, the underlying Si in the wafer is not consumed. This is called a deposited layer. In some embodiments, the insulator layer 227 helps in protecting the components in the support structure 220 from contamination, both physical and chemical. Thus, it acts as a passivating layer. The insulator layer 227 can protect the components in the support structure 220 from scratches and it also prevents dust from interacting with the components in the support structure 220, and thus minimizes contamination. The insulator layer 227 also protects the components in the support structure 220 from chemical impurities, mainly electrically active contaminants. SiOx acts as a hard mask for doping and as an etch stop during patterning.

The BPRs 210 and 215 are electrically conductive. The BPRs 210 and 215 are coupled to one or more power sources and to semiconductor devices in the IC device 200 (such as the transistors 230) to provide power to the semiconductor devices. In FIG. 2, the two BPRs 210 and 215 are buried in the support structure 220. A portion of each BPR 210 or 215 is buried in the insulator layer 227. The remaining portion of each BPR 210 or 215 is buried in the semiconductor layer 225. The BPRs 210 and 215 may be made of a metal, such as tungsten (W), ruthenium (Ru), cobalt (Co), other metals, or some combination thereof. Each BPR 210 or 215 may include a dielectric barrier on its surface that touches the semiconductor layer 225. The dielectric barrier can insulate the metal in the BPR 210 or 215 from the semiconductor material of the semiconductor layer 225. The dielectric barrier may be an oxide barrier made from an oxide material.

The electrically conductive layers 240, 250, and 260 are built in the IC device 200 to provide power and signal to the semiconductor devices in the IC device 200. An electrically conductive layer is a layer comprising an electrically conductive material, e.g., metal. In an embodiment, the electrically conductive layers 240 and 260 are used for power delivery but the electrically conductive layer 250 is used for signal delivery. In some embodiments, the electrically conductive layer 260 is referred to as "M0," the electrically conductive layer 250 is referred to as "Mint," and the electrically conductive layer 260 is referred to as "M1," given the sequence of producing the electrically conductive layers 240, 250, and 260 in the process of fabricating the IC device 200. The electrically conductive layers 240, 250, and 260 can be made of copper or other types of metals. Each electrically conductive layer 240, 250, or 260 includes multiple sections that can be separated and insulated from each other.

The BPRs 210 and 215, electrically conductive layers 240, 250, and 260, and vias 245, 255, and 265 constitute a conducting path for power delivery network, as indicated by the dotted line in FIG. 2. The vias 245, 255, and 265 are conducting. In one embodiment, some or all of the vias 245, 255, and 265 are made of copper or other types of metal. The vias 245 are between the electrically conductive layers 240 and 250 to couple the two electrically conductive layers 240 and 250 to each other. As shown in FIG. 2, there are three vias 245 between the electrically conductive layers 240 and 250. Each via 245 is for coupling a section of the electrically conductive layer 240 to a corresponding section of the electrically conductive layer 250. In other embodiments, there can be fewer or more vias 245 to couple the electrically conductive layers 240 and 250. Similarly, the via 255 is between the electrically conductive layers 250 and 260. The vias 265 couple the BPRs 210 and 215 to the electrically conductive layer 260. In FIG. 2, there are two vias 265 connecting the BPR 210 to the electrically conductive layer 260 and two vias 265 connecting the BPR 215 to the electrically conductive layer 260. The electrically conductive layer 260 is coupled to the transistors 230, particularly to semiconductor structures 235 of the transistors 230.

In an example, the electrically conductive layer 240 functions as the power plane of the IC device 200. A positive or negative voltage, for example, can be provided to the electrically conductive layer 240 so that the BPR 210 is electrically biased. The BPR 215 is grounded so that there is an electric potential difference between the BPRs 210 and 215, which transfers to the electric potential difference between the transistors 230. As the electrically conductive layer 240 is on top of the transistors 230, the power delivery network is called "frontside power delivery network." In other embodiments, the IC device 200 may include a electrically conductive layer below the transistors 230, e.g., at the backside of the IC device 200. The electrically conductive layer may function as the power plane, ground plane, or both to form "backside power delivery network". The BPRs 210 and 215 can be coupled to the electrically conductive layer by TSVs. The TSVs are below the BPRs 210 and 215 and buried in the semiconductor layer 225 of the support structure 220. The TSVs may be micro-TSVs or nano-TSVs. The power delivery network of the IC device 200 can be a network of interconnect that is separate from the signal network. For instance, portions of the electrically conductive layer 250 that are not in the power delivery network can be used to deliver signals.

In addition to power delivery, the BPRs 210 and 215 are also used for backside heat dissipation in the embodiment of FIG. 2. The BPRs 210 and 215 are connected to the TSVs 280 and 285, respectively. The TSVs 280 and 285 are buried in the semiconductor layer 225 of the support structure 220. The TSVs 280 and 285 connect the BPRs 210 and 215 to the heat dissipation plate 270. The heat dissipation plate 270 is thermally conductive. The heat dissipation plate 270 may be made of metal (e.g., copper, aluminum, etc.) or other types of thermally conductive material. The heat dissipation plate 270 adjoins the bottom surface of the semiconductor layer 225, which is the backside 290 of the support structure 220. Thus, heat generated at or around the semiconductor structures 235 can be delivered out of the support structure 220 through a path including the electrically conductive layer 260, vias 265, BPRs 210 and 215, TSVs 280 and 285, and the heat dissipation plate 270. As the heat is dissipated to the backside of the support structure 220, this is referred to as "backside heat dissipation."

In the embodiment of FIG. 1, as the BPRs 210 and 215 are used for power delivery, the heat dissipation plate 270 is formed with a gap 277 that separates the heat dissipation plate 270 into two sections 273 and 275 to avoid electrical shortage between the BPRs 210 and 215. The gap 277, in some embodiments, may be filled with a dielectric material for electrically insulating the BPR 210 from the BPR 215. In other embodiments, the IC device 200 includes BHRs separate from BPRs, i.e., the BHRs are not used for power delivery. In these embodiments, the heat dissipation plate 270 may be one piece.

In some embodiments, the IC device 200 is fabricated through a sequence of processes. Well formation is done as the first step. The first step comprises, for example, ion implantation and dopant activation anneal. Alternatively, well formation can be done after the fin reveal step. Subsequently, fin patterning and insulator layer formation are carried out. The insulator layer formation step may include silicon oxide deposition, silicon oxide anneal, and chemical mechanical polishing (CMP). The BPRs 210 and 215 are formed in the next step, which includes patterning BPR trench into the support structure 220. Subsequently, a dielectric barrier may be deposited onto the outer surfaces of the BPRs 210 and 215 (i.e., the surfaces touching the support structure 220) to electrically isolate the BPRs 210 and 215 from the support structure 220. In some embodiments, the step of forming the BPRs 210 and 215 may further include metal CMP and silicon oxide anneal. Next, fin reveal is carried out, e.g., by etching, to reveal the fins. After that, the electrically conductive layers 240, 250, and 260 and vias 245, 255, and 265 are integrated into the IC device 200.

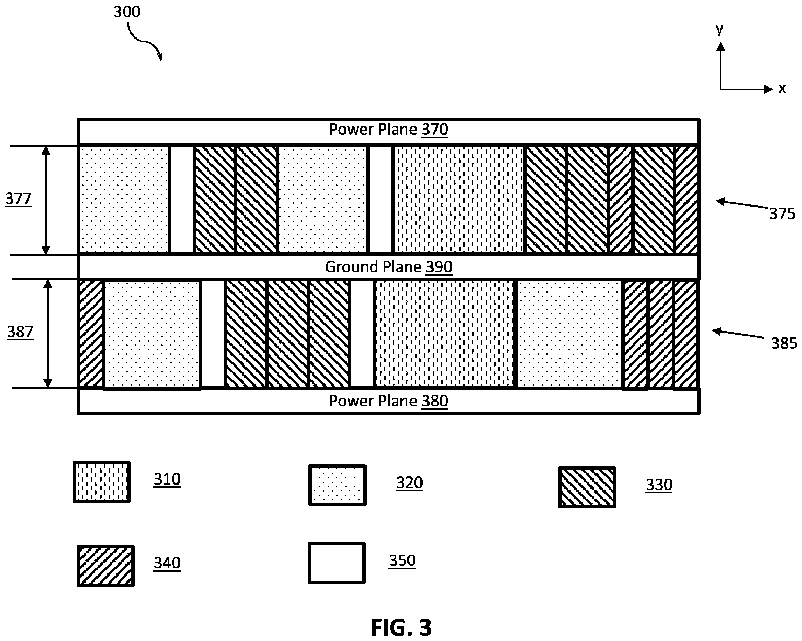

FIG. 3 is a top view of an example IC device 300 including a plurality of cells, according to some embodiments of the disclosure. A cell is a block in the IC device 300. The cells are arranged in two rows 375 and 385 defined by two power planes 370 and 380 and a ground plane 390. In some embodiments, each of the power planes 370 and 380 and ground plane 390 is a metal layer in the IC device. The power planes 370 and 380 can be coupled to a power source that providing a positive or negative voltage to the IC device 300. In an embodiment, the power planes 370 and 380 are two separate metal layers that are electrically insulated from each other and can be coupled to the same or two different power sources. In another embodiment, the power planes 370 and 380 are one metal layer, e.g., a curved metal layer that encloses the ground plane 390. The ground plane 390 is grounded, so that there is an electrical potential between the group plane 390 and each power plane 370 or 380. The power planes 370 and 380 and ground plane 390 are electrically coupled to BPRs, vias, and other metal layers, which form a power delivery network of the IC device 300.

In FIG. 3, the cells in each row 375 or 385 are fixed-height blocks with variable width. The heights of the cells depend on the distance from the ground plane 380 to the corresponding power plane 370 or 380 along the y-axis. The cells in the row 375 all have a height 377. The cells in the row 385 all have a height 387. The widths of the cells can be variable.

The cells include filler cells 350 (individually referred to as "filler cell") and logic cells. A filler cell 350 is an inactive block in the IC device 300 and does not implement any logic functions. A filler cell 350 may be used for various purposes, e.g., heat dissipation, voltage stability (also known as decoupling capacitorss), isolation, and so on. In one example, a filler cell 350 may include a heat dissipation plate for dissipating heat generated by the operation of logic cells adjacent to the filler cell 350. As another example, the filler cell 350 may be filled with an electrical insulator to insulate logic cells adjacent to the filler cell 350. For instance. As yet another example, one or more capacitors can be placed in a filler cell 350 and the filler cell 350 functions as a decap cell that stores charges and supports current requirement in the power delivery network of the IC device 300. A filler cell 350 including capacitors may also be an end cap cell that protects an adjacent logic cell near the boundary of the IC device 300 from damage during manufacturing.

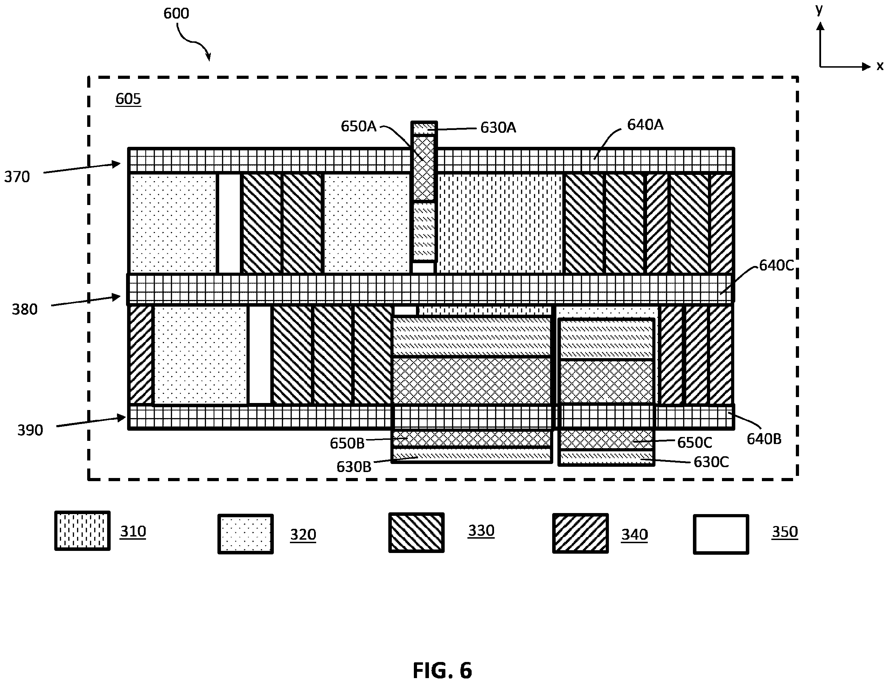

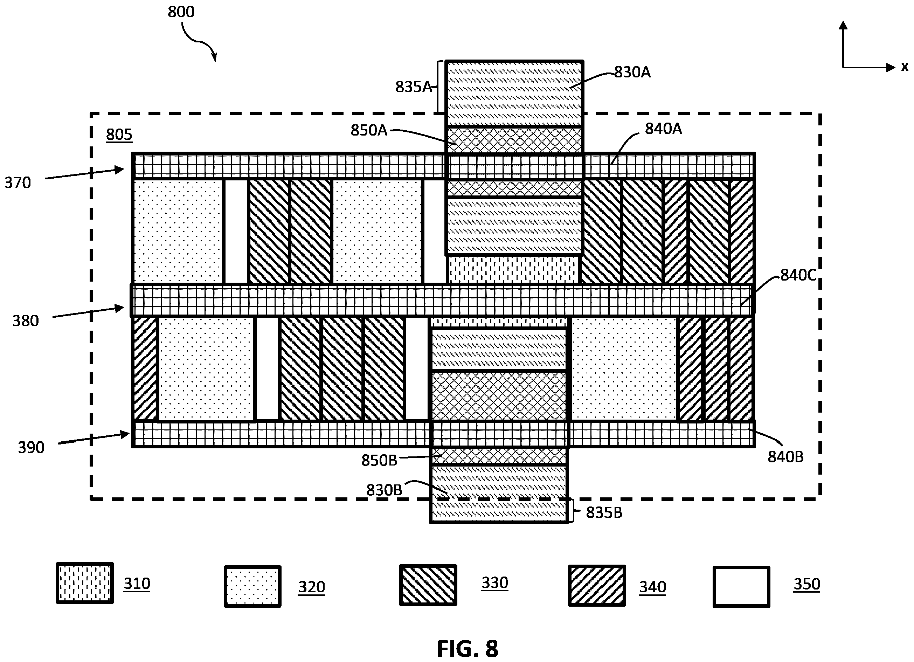

A logic cell implements one or more logic functions. A logic cell may include simple gates such as "AND" and "OR" and may also include other components, such as multiplexers, buffers, latches, and flip-flops. One or more transistors can be arranged in each logic cell. In some embodiments, a logic cell can be a modular that is independent from other cells. In other embodiments, a logic cell be linked to other logic cells to form a complex logic. Within each row 375 or 385, logic cells of varying widths can be placed. The width of a logic cell may depend on the type of logic implemented by the logic cell. The logic cells in FIG. 3 have four different widths. The logic cells with the largest width are referred to as very large cells 310, the logic cells with the second largest width are referred to as large cells 320, the logic cells with the third largest width are referred to as small cells 330, and the logic cells with the fourth largest width are referred to as tiny cells 340. In some embodiments, a logic cell having a larger width may implement a more complicated logic function, compared with a logic cell having a smaller width. High drive strength logic cells, e.g., a very large cell 310, can generate more heat during their operations. A high drive strength cell, such as a strong buffer or inverter can cause high electrical currents and accordingly more heat. A cell with higher drive strength usually has a larger size. In some embodiments, a filler cell 350 adjoining a very large cell 310 can be used for dissipating heat from the very large cell 310. More details regarding using filler cells for dissipating heat are described below in conjunction with FIGS. 6 and 8.

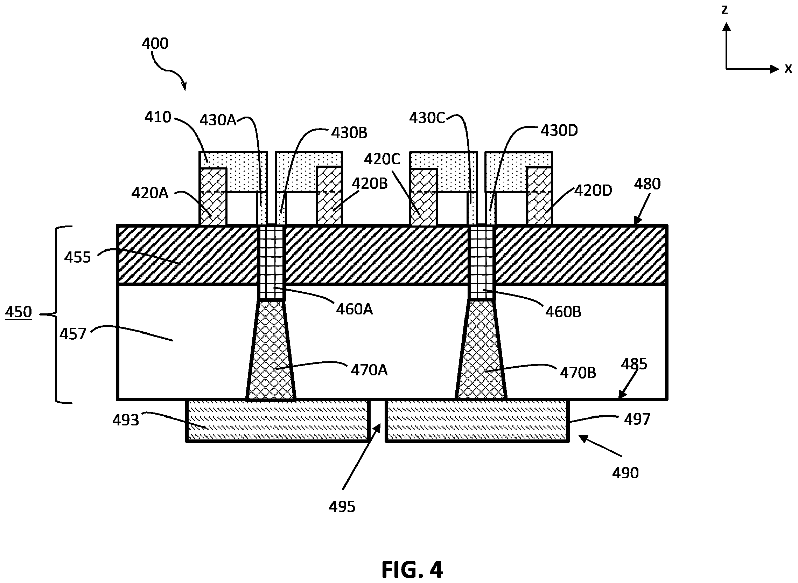

FIG. 4 is a cross-sectional view of an example IC device 400 including BHRs 460A-B and TSVs 470 A-B for heat dissipation, according to some embodiments of the disclosure. The IC device 400 includes an electrically conductive layer 410, fins 420A-D (collectively referred to as "fins 420" or "fin 420"), vias 430A-D (collectively referred to as "vias 430" or "via 430"), a support structure 450, the BHRs 460A-B (collectively referred to as "BHRs 460" or "BHR 460"), the TSVs 470A-B (collectively referred to as "TSVs 470" or "TSV 470"), and a heat dissipation plate 490. In other embodiments, the IC device 400 may include fewer, more, or different components.

The electrically conductive layer 410 is electrically coupled to the fins 420. The electrically conductive layer 410 can be an embodiment of the electrically conductive layer 260 in FIG. 2. The electrically conductive layer 410 can be part of the power delivery network of the IC device 400 and deliver power to the fins. The fins 420 are semiconductor structures of transistors, e.g., transistors for conducting logic functions. For instance, the fins A-B are within one transistor and the fins C-D are within another transistor. The transistors also include gates, which are not shown in FIG. 4. In other embodiments, the semiconductor structures may be nanoribbons, nanosheets, or other types of semiconductor structures.

The electrically conductive layer 410 is connected to the BHRs 460 through the vias 430. Each via may include a material that is thermally conductive, e.g., a metal. In the embodiment of FIG. 4, each via 430 corresponds to a fin 420. For instance, the via 430A is connected to a portion of the electrically conductive layer 410 that is electrically coupled to the fin 420A and connects the portion of the electrically conductive layer 410 to the BHR 460A. Similarly, the via 430B is connected to the portion of the electrically conductive layer 410 coupled to the fin 420B, the via 430C is connected the portion of the electrically conductive layer 410 coupled to the fin 420C, and the via 430D is connected to the portion of the electrically conductive layer 410 coupled to the fin 420D. With the vias 430, the fins 420A-B are electrically and thermally coupled to the BHR 460A, and the fins 420C-D are electrically and thermally coupled to the BHR 460B.

The BHRs 460 and TSVs 470 are buried in the support structure 450 and used for backside heat dissipation. The BHRs 460 are connected to the TSVs 470: the BHR 460A is connected to the TSV 470A and the BHR 460B is connected to the TSV 470B. In the embodiment of FIG. 4, the bottom surface of a BHR 460 contacts with the top surface of its corresponding TSV 470. The size of the bottom surface of the BHR 460 is the same as or similar to the top surface of its corresponding TSV 470. The TSVs 470 are connected to the heat dissipation plate 490. In the direction along the x-axis, each pair of BHR 460 and TSV 470 is between two adjacent semiconductor structures and used for dissipating heat from the two semiconductor structures. The two semiconductor structures may be of a same transistor or different transistors. As shown in FIG. 4, the BHR 460A and TSV 470A is between the fin 420A and fin 420B. As the BHR 460A is connected to the vias 430A and 430B, which are coupled to the fins 420A-B, the BHR 460A and TSV 470A can sink heat generated by the fins 420A-B to the heat dissipation plate 490. Similarly, the BHR 460B and TSV 470B are between the fin 420C and fin 420D and can sink heat generated by the fins 420C-D to the heat dissipation plate 490. A TSV 470 may be a micro-TSV, the diameter of which is above 1 µm, or a nano-TSV, the diameter of which is below 1 µm (such as a few hundreds of nanometers). The TSVs 470 are connected to the heat dissipation plate 490.

The heat dissipation plate 490 is thermally conductive for dissipating heat. An embodiment of the heat dissipation plate 490 is a metal plate. The heat dissipation plate 490 includes two sections 493 and 497, which are separated from each other by a gap 495. The gap 495 electrically insulates the two sections 493 and 497 from each other to avoid electrical shortage between the BHRs 460. The gap 495 may be filled with an electrical insulator. In some embodiments, the heat dissipation plate 490 is also used for power delivery. For instance, the section 493 may be a ground plane of the IC device and the section 497 may be a power plane (or vice versa). The power can be delivered from the heat dissipation plate 490 to the fins 420 through the TSVs 470, BHRs 460, vias 430, and electrically conductive layer 410. In FIG. 4, the heat dissipation plate 490 is located at the backside of the substate 450 for backside heat dissipation.

The support structure 450 includes a semiconductor layer 455 and an insulator layer 457. The semiconductor layer 455 may be a layer of silicon. The insulator layer 457 may be a layer of an oxide material. As shown in FIG. 4, a portion of each BHR 460 is buried in the semiconductor layer 455 and the remaining portion of each BHR 460 is buried in the insulator layer 457. The support structure 450 includes two surfaces 480 and 485. The fins 420 are on the surface 480. The surface 485 defines the backside of the support structure 450. The surface 485 contacts with the heat dissipation plate 490.

In some embodiments, some or all of the BHRs 460, TSVs 470, and heat dissipation plate 490 may also be part of the power delivery network of the IC device 400. For instance, the BHRs 460 are power rails buried in the support structure 450. In embodiments where the IC device 400 has a frontside power delivery network, the BHRs 460 are electrically coupled to a power plane or ground plane, such as an additional electrically conductive layer on top of the electrically conductive layer 410. Electrical current can flow to the fins 420 through the BHRs 460, vias 430, and the electrically conductive layer 410. In embodiments where the IC device 400 has a backside power delivery network, the BHRs 460 can be coupled to an electrically conductive layer at the backside of the support structure 450 through TSVs, e.g., the TSVs 470. The electrically conductive layer may be the heat dissipation plate 490 or separated from the heat dissipation plate 490.

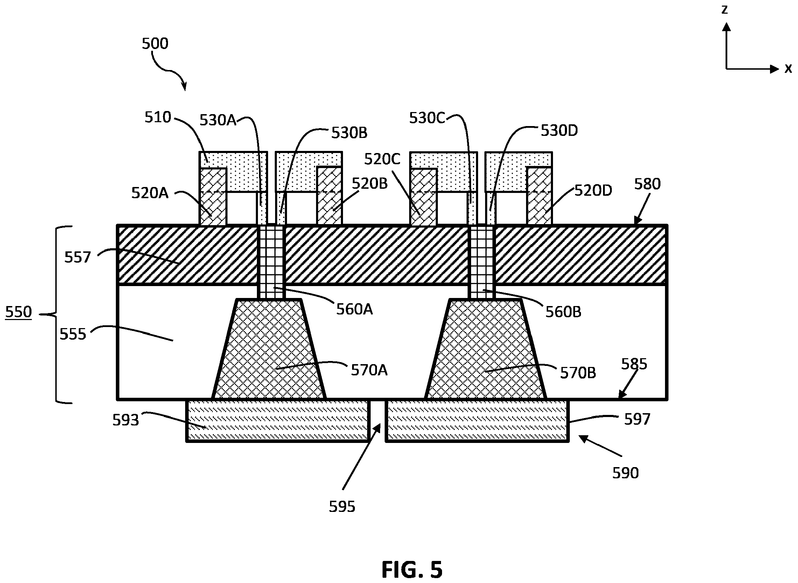

FIG. 5 is a cross-sectional view of an example IC device 500 including BHRs 560A-B and enlarged TSVs 570 A-B for heat dissipation, according to some embodiments of the disclosure. The IC device 500 includes an electrically conductive layer 510, fins 520A-D (collectively referred to as "fins 520" or "fin 520"), vias 530A-D (collectively referred to as "vias 530" or "via 530"), a support structure 550, the BHRs 560A-B (collectively referred to as "BHRs 560" or "BHR 560"), the enlarged TSVs 570A-B (collectively referred to as "enlarged TSVs 570" or "enlarged TSV 570"), and a heat dissipation plate 590. In other embodiments, the IC device 500 may include fewer, more, or different components.

The electrically conductive layer 510 is electrically coupled to the fins 520. The electrically conductive layer 510 can be an embodiment of the electrically conductive layer 260 in FIG. 2. The electrically conductive layer 510 can be part of the power delivery network of the IC device 500 and deliver power to the fins. The fins 520 are semiconductor structures of transistors, e.g., transistors for conducting logic functions. For instance, the fins A-B are within one transistor and the fins C-D are within another transistor. The transistors also include gates, which are not shown in FIG. 5. In other embodiments, the semiconductor structures may be nanoribbons, nanosheets, or other types of semiconductor structures.

The electrically conductive layer 510 is connected to the BHRs 560 through the vias 530. Each via may include a material that is thermally conductive, e.g., a metal. In the embodiment of FIG. 5, each via 530 corresponds to a fin 520. For instance, the via 530A is connected to a portion of the electrically conductive layer 510 that is electrically coupled to the fin 520A and connects the portion of the electrically conductive layer 510 to the BHR 560A. Similarly, the via 530B is connected the portion of the electrically conductive layer 510 coupled to the fin 520B, the via 530C is connected the portion of the electrically conductive layer 510 coupled to the fin 520C, and the via 530D is connected the portion of the electrically conductive layer 510 coupled to the fin 520D. With the vias 530, the fins 520A-B are electrically and thermally coupled to the BHR 560A, and the fins 520C-D are electrically and thermally coupled to the BHR 560B.

The BHRs 560 and enlarged TSVs 570 are buried in the support structure 550. The bottom surface of each BHR 560 contacts with the top surface of the corresponding TSV 570. As shown in FIG. 5, the TSVs 570 are enlarged with respect to the BHRs 560. Each enlarged TSV 570 has a larger cross-section than its corresponding BHR 560, i.e., the size of the top surface of the enlarged TSV 570 is larger than the size of the bottom surface of the BHR 560. That is why the TSVs are called "enlarged TSVs." Compared with the TSVs 570 in FIG. 5, the enlarged TSVs 570 can sink heat more efficiently given their bigger cross-sectional size. For instance, a larger cross-section can reduce thermal resistance, which results in more efficient heat dissipation. Each TSV in FIG. 5 is enlarged. In other embodiments, the IC device 500 may include a mix of enlarged TSVs and regular TSVs (such as the TSVs 470 in FIG. 4). For instance, the TSV for fins generating a larger amount of heat is enlarged, but the TSV for fins generating a smaller amount of heat is not enlarged. An enlarged TSV 570 may be a micro-TSV, the diameter of which is above 1 µm, or a nano-TSV, the diameter of which is below 1 µm (such as a few hundreds of nanometers). The enlarged TSVs 570 are connected to the heat dissipation plate 490.

The heat dissipation plate 590 is thermally conductive for dissipating heat. An embodiment of the heat dissipation plate 590 is a metal plate. The heat dissipation plate 590 includes two sections 593 and 597, which are separated from each other by a gap 595. The gap 595 electrically insulates the two sections 593 and 597 from each other to avoid electrical shortage between the BHRs 560. The gap 595 may be filled with an electrical insulator. In some embodiments, the heat dissipation plate 590 is also used for power delivery. For instance, the section 593 may be a ground plane of the IC device and the section 597 may be a power plane (or vice versa). The power can be delivered from the heat dissipation plate 590 to the fins 520 through the TSVs 570, BHRs 560, vias 530, and electrically conductive layer 510. In FIG. 5, the heat dissipation plate 590 is located at the backside of the substate 550 for backside heat dissipation.

The support structure 550 includes a semiconductor layer 555 and an insulator layer 557. The semiconductor layer 555 may be a layer of silicon. The insulator layer 557 may be a layer of an oxide material. As shown in FIG. 5, a portion of each BHR 560 is buried in the semiconductor layer 555 and the remaining portion of each BHR 560 is buried in the insulator layer 557. The support structure 550 includes two surfaces 580 and 585. The fins 520 are on the surface 580. The surface 585 defines the backside of the support structure 550. The surface 585 contacts with the heat dissipation plate 590.

In some embodiments, some or all of the BHRs 560, TSVs 570, and heat dissipation plate 590 may also be part of the power delivery network of the IC device 500. For instance, the BHRs 560 are power rails buried in the support structure 550. In embodiments where the IC device 500 has a frontside power delivery network, the BHRs 560 are electrically coupled to a power plane or ground plane, such as an additional electrically conductive layer on top of the electrically conductive layer 510. Electrical current can flow to the fins 520 through the BHRs 560, vias 530, and the electrically conductive layer 510. In embodiments where the IC device 500 has a backside power delivery network, the BHRs 560 can be coupled to an electrically conductive layer at the backside of the support structure 550 through TSVs, e.g., the TSVs 570. The electrically conductive layer may be the heat dissipation plate 590 or separated from the heat dissipation plate 590.

FIG. 6 is a top view of an example IC device 600 including filler cells 350 used for heat dissipation, according to some embodiments of the disclosure. The IC device 600 includes the four filler cells 350 and logic cells described above in conjunction with FIG. 3. FIG. 6 also shows BPRs 640A-C coupled to the power planes 370 and 380 and ground plane 390. The BPRS 640A-C are buried in a support structure 605. An embodiment of the support structure 605 is the support structure 220 in FIG. 2, the support structure 450 in FIG. 4, or the support structure 550 in FIG. 5.

The embodiment of FIG. 6 takes advantage of the two filler cells 350, each of which is adjacent to a very large cell 310, for dissipating heat generated by the very large cell 310. In the embodiment of FIG. 6, each of the two filler cells 350 adjoins a very large cell 310. As described above, larger logic cells may be used for implementing more complicated logic functions compared with smaller logic cells (i.e., logic cells having smaller widths). Consequently, operations of the larger logic cells can generate more heat than the smaller logic cells. Thus, more efficient heat dissipation may be needed for high drive strength cells, such as the two very large cell 310 in FIG. 6.

For the very large cell 310 between the power plane 370 and ground plane 380, a heat dissipation plate 630A is placed in the filler cell 350 adjoining the very large cell 310. Also, a TSV 650A is connecting the BPR 640A, which is coupled to the power plane 370, to the heat dissipation plate 630A. Thus, the BPR 640A, TSV 650A, and heat dissipation plate 630A enables dissipation of heat generated by the very large cell 310 through the filler cell 350. As the filler cell 350 is inactive and does not generate heat, the filler cell 350 provides space for dissipating heat from the very large cell 310, especially in embodiments where it is difficult to put TSVs or heat dissipation plates directly below the very large cell 310 due to limited space or other types of conflicts.

For the very large cell 310 between the power plane 390 and ground plane 380, a heat dissipation plate 630B is placed in the filler cell 350 adjoining the very large cell 310 and the very large cell 310 itself. A TSV 650B is connecting the BPR 640B, which is coupled to the power plane 390, to the heat dissipation plate 630B. Thus, the BPR 640B, TSV 650B, and heat dissipation plate 630B enables dissipation of heat generated by the very large cell 310 through both the very large cell 310 itself and the filler cell 350.

For a logic cell that is not adjacent to any filler cells 350, the heat dissipation can be done through a heat dissipation plate arranged in the logic cell itself. As shown in FIG. 6, a heat dissipation plate 630C and TSV 650C are present in a large cell 320 between the power plane 390 and ground plane 380. In some embodiments, a heat dissipation plate (or a portion of it) for a logic cell may be arranged in adjacent logic cell(s) that generates less heat than the logic cell. For instance, the adjacent logic cell causes lower electrical currents, which results in lower heat.

In the embodiment of FIG. 6, the BPRs 640A-C are used for both power delivery and heat dissipation. In other embodiments, the IC device 600 may include BPRs for power delivery and BHRs for heat dissipation. The BHRs can be separate from the BPRs.

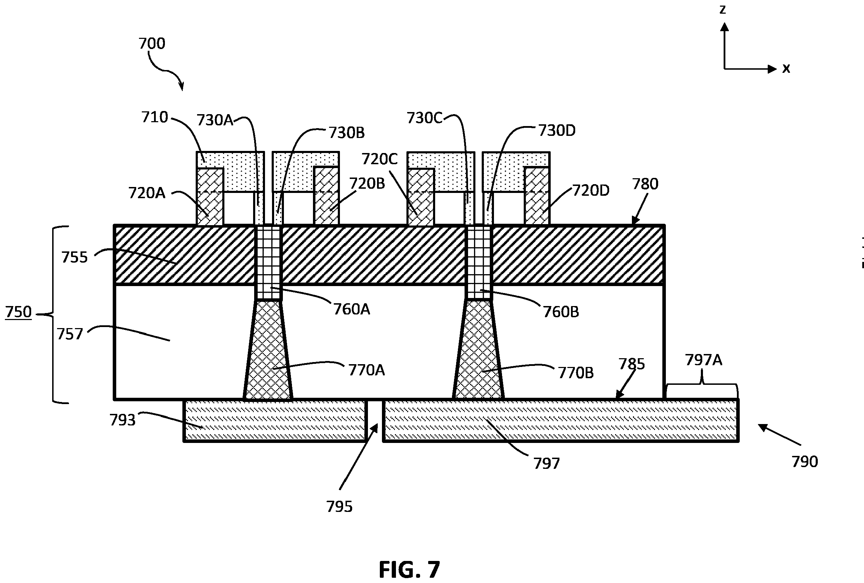

FIG. 7 is a cross-sectional view of an example IC device 700 including an exceeding heat dissipation plate 790, according to some embodiments of the disclosure. The IC device 700 includes an electrically conductive layer 710, fins 720A-D (collectively referred to as "fins 720" or "fin 720"), vias 730A-D (collectively referred to as "vias 730" or "via 730"), a support structure 750, BHRs 760A-B (collectively referred to as "BHRs 760" or "BHR 760"), TSVs 770A-B (collectively referred to as "TSVs 770" or "TSV 770"), and the exceeding heat dissipation plate 790. In other embodiments, the IC device 700 may include fewer, more, or different components.

The electrically conductive layer 710 is electrically coupled to the fins 720. The electrically conductive layer 710 can be an embodiment of the electrically conductive layer 260 in FIG. 2. The electrically conductive layer 710 can be part of the power delivery network of the IC device 700 and deliver power to the fins. The fins 720 are semiconductor structures of transistors, e.g., transistors for conducting logic functions. For instance, the fins A-B are within one transistor and the fins C-D are within another transistor. The transistors also include gates, which are not shown in FIG. 7. In other embodiments, the semiconductor structures may be nanoribbons, nanosheets, or other types of semiconductor structures.

The electrically conductive layer 710 is coupled to the BHRs 760 through the vias 730. Each via may include a material that is thermally conductive, e.g., a metal. In the embodiment of FIG. 7, each via 730 corresponds to a fin 720. For instance, the via 730A is connected to a portion of the electrically conductive layer 710 that is electrically coupled to the fin 720A and connects the portion of the electrically conductive layer 710 to the BHR 760A. Similarly, the via 730B is connected the portion of the electrically conductive layer 710 coupled to the fin 720B, the via 730C is connected the portion of the electrically conductive layer 710 coupled to the fin 720C, and the via 730D is connected the portion of the electrically conductive layer 710 coupled to the fin 720D. With the vias 730, the fins 720A-B are electrically and thermally coupled to the BHR 760A, and the fins 720C-D are electrically and thermally coupled to the BHR 760B.

The BHRs 760 and TSVs 770 are buried in the support structure 750 and used for backside heat dissipation. The BHRs 760 are connected to the TSVs 770: the BHR 760A is connected to the TSV 770A and the BHR 760B is connected to the TSV 770B. In the embodiment of FIG. 7, the bottom surface of a BHR 760 contacts with the top surface of its corresponding TSV 770. The size of the bottom surface of the BHR 760 is the same as or similar to the top surface of its corresponding TSV 770. The TSVs 770 are connected to the exceeding heat dissipation plate 790. In the direction along the x-axis, each pair of BHR 760 and TSV 770 is between two fins and used for dissipating heat from the two fins. For instance, the BHR 760A and TSV 770A is between the fin 720A and fin 720B. As the BHR 760A is connected to the vias 730A and 730B, which are coupled to the fins 720A-B, the BHR 760A and TSV 770A can sink heat generated by the fins 720A-B to the exceeding heat dissipation plate 790. Similarly, the BHR 760B and TSV 770B are between the fin 720C and fin 720D and can sink heat generated by the fins 720C-D to the exceeding heat dissipation plate 790. A TSV 770 may be a micro-TSV, the diameter of which is above 1 µm, or a nano-TSV, the diameter of which is below 1 µm (such as a few hundreds of nanometers). The TSVs 770 are connected to the exceeding heat dissipation plate 790.

The exceeding heat dissipation plate 790 is thermally conductive for dissipating heat. An embodiment of the exceeding heat dissipation plate 790 is a metal plate. The exceeding heat dissipation plate 790 includes two sections 793 and 797, which are separated from each other by a gap 795. As shown in FIG. 7, the section 797 has a portion 797A that exceeds the support structure 750. In other words, even though the section 795 and the rest of the section 797 adjoins the support structure 750, the portion 797A does not adjoin the support structure 750. With the portion 797A exceeding the support structure 750, the exceeding heat dissipation plate 790 can conduct heat from the fins 720 to an area beyond the backside of the support structure 750, which can improve the efficiency of heat dissipation. With the portion 797A, the exceeding heat dissipation plates 790 can conduct the heated generated by the fins 720 to a bigger area. In other words, the area for sinking heat is increased. Also, the portion 797A can be arranged at a block (e.g., an inactive block) of the IC device 700 that has a lower temperature than the support structure 750. Thus, a larger temperature difference is created between the portion 797A and the fins 720, which enhances the kinetics of heat dissipation. The length of the portion 797A along the x-axis may be limited by a dimension of the block. The embodiment of FIG. 1 shows the exceeding heat dissipation plate 790 exceeds one side of the support structure 750. In other embodiments, the exceeding heat dissipation plate 790 may exceed the support structure 750 from the other side or both sides. For instance, the section 793 may exceed the support structure 750, or both sections 793 and 797 may exceed the support structure 750. The gap 795 electrically insulates the two sections 793 and 797 from each other to avoid electrical shortage between the BHRs 760. The gap 795 may be filled with an electrical insulator. In some embodiments, the exceeding heat dissipation plate 790 is also used for power delivery. For instance, the section 793 may be a ground plane of the IC device and the section 797 may be a power plane (or vice versa). The power can be delivered from the exceeding heat dissipation plate 790 to the fins 720 through the TSVs 770, BHRs 760, vias 730, and electrically conductive layer 710. In FIG. 7, the exceeding heat dissipation plate 790 is located at the backside of the substate 750 for backside heat dissipation.

The support structure 750 includes a semiconductor layer 755 and an insulator layer 757. The semiconductor layer 755 may be a layer of silicon. The insulator layer 757 may be a layer of an oxide material. As shown in FIG. 7, a portion of each BHR 760 is buried in the semiconductor layer 755 and the remaining portion of each BHR 760 is buried in the insulator layer 757. The support structure 750 includes two surfaces 780 and 785. The fins 720 are on the surface 780. The surface 785 defines the backside of the support structure 750. The surface 785 contacts with the exceeding heat dissipation plate 790.

In some embodiments, some or all of the BHRs 760, TSVs 770, and exceeding heat dissipation plate 790 may also be part of the power delivery network of the IC device 700. For instance, the BHRs 760 are power rails buried in the support structure 750. In embodiments where the IC device 700 has a frontside power delivery network, the BHRs 760 are electrically coupled to a power plane or ground plane, such as an additional electrically conductive layer on top of the electrically conductive layer 710. Electrical current can flow to the fins 720 through the BHRs 760, vias 730, and the electrically conductive layer 710. In embodiments where the IC device 700 has a backside power delivery network, the BHRs 760 can be coupled to an electrically conductive layer at the backside of the support structure 750 through TSVs, e.g., the TSVs 770. The electrically conductive layer may be the exceeding heat dissipation plate 790 or separated from the exceeding heat dissipation plate 790.

FIG. 8 is a top view of an example IC device 800 including exceeding heat dissipation plates 830A-B, according to some embodiments of the disclosure. The IC device 800 include the logic cells 310, 320, 330, and 340 as well as the filler cells 350 described above in conjunction with FIG. 3. FIG. 8 also shows BPRs 840A-C coupled to the power planes 370 and 380 and ground plane 390. The BPRS 840A-C are buried in a support structure 805. An embodiment of the support structure 805 is the support structure 750 in FIG. 7.

The embodiment of FIG. 8 uses exceeding heat dissipation plates 830A-B collectively referred to as "exceeding heat dissipation plates 830" or "exceeding heat dissipation plate 830") for conducting heat generated by the two very large cells 310. As described above, larger logic cells may be high driven strength cells. Consequently, operations of the larger logic cells can generate more heat than the smaller logic cells. Thus, more efficient heat dissipation may be needed for the larger logic cells, such as the two very large cell 310 in FIG. 8. In some embodiments, exceeding heat dissipation plates can be used to dissipating heat generated by other logic cells, such as the large cell 320, the small cells 330, or even the tiny cells 340. As shown in FIG. 8, the exceeding heat dissipation plate 830A has a portion 835A beyond the top boundary of the support structure 805 in the z-axis direction. Similarly, the exceeding heat dissipation plate 830B has a portion 835B beyond the bottom boundary of the support structure 805 in the z-axis direction. With the portions 835A-B (collectively referred to as "portions 835" or "portion 835"), the exceeding heat dissipation plates 830A-B can conduct the heated generated by the very large cells 310 to a bigger area. In other words, the area for sinking heat is increased. Also, the portion 835 can be arranged at a block (e.g., an inactive block) of the IC device 800 that has a lower temperature than the very large cell 310. Thus, a temperature difference is created between the portion 835 and the very large cell 310, which enhances the kinetics of heat dissipation.

As shown in FIG. 8, for the very large cell 310 between the power plane 370 and ground plane 380, an exceeding heat dissipation plate 830A is placed in the filler cell 350 adjoining the very large cell 310. Also, a TSV 850A is connecting the BPR 840A, which is coupled to the power plane 370, to the exceeding heat dissipation plate 830A. Thus, the BPR 840A, TSV 850A, and exceeding heat dissipation plate 830A enables dissipation of heat generated by the very large cell 310. For the very large cell 310 between the power plane 390 and ground plane 380, an exceeding heat dissipation plate 830B is placed in the filler cell 350 adjoining the very large cell 310 and the very large cell 310 itself. A TSV 850B is connecting the BPR 840B, which is coupled to the power plane 390, to the exceeding heat dissipation plate 830B. Thus, the BPR 840B, TSV 850B, and exceeding heat dissipation plate 830B enables dissipation of heat generated by the very large cell 310.

Even though not shown in FIG. 8, an exceeding heat dissipation plate 830, or a portion of it, may be at the filler cell 350 adjacent to the very large cell 310 to sink heat from the very large cell 310 to the filler cell, which can further improve the heat dissipation efficiency. Also, some or all of the other logic cells 320, 330, and 340 may have heat dissipation plates or exceeding heat dissipation plates. In the embodiment of FIG. 8, the BPRs 840A-C are used for both power delivery and heat dissipation. In other embodiments, the IC device 800 may include BPRs for power delivery and BHRs for heat dissipation. The BHRs can be separate from the BPRs.

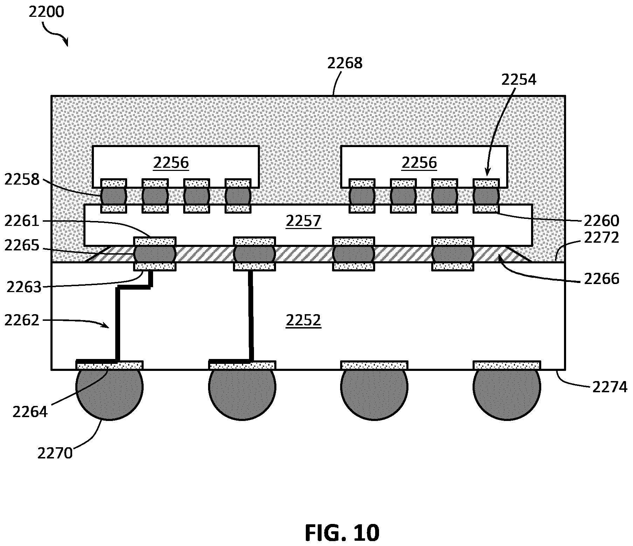

FIGS. 9A-9B are top views of a wafer 2000 and dies 2002 that may include one or more BHRs, according to some embodiments of the disclosure. In some embodiments, the dies 2002 may be included in an IC package, in accordance with any of the embodiments disclosed herein. For example, any of the dies 2002 may serve as any of the dies 2256 in an IC package 2200 shown in FIG. 10. The wafer 2000 may be composed of semiconductor material and may include one or more dies 2002 having IC devices formed on a surface of the wafer 2000. Each of the dies 2002 may be a repeating unit of a semiconductor product that includes any suitable IC (e.g., ICs including one or more BHRs as described herein). After the fabrication of the semiconductor product is complete (e.g., after manufacture of one or more BHRs as described herein), the wafer 2000 may undergo a singulation process in which each of the dies 2002 is separated from one another to provide discrete "chips" of the semiconductor product. In particular, devices that include one or more BHRs as disclosed herein may take the form of the wafer 2000 (e.g., not singulated) or the form of the die 2002 (e.g., singulated). The die 2002 may include one or more diodes (e.g., one or more BHRs as described herein), one or more transistors (e.g., one or more III-N transistors as described herein) as well as, optionally, supporting circuitry to route electrical signals to the III-N diodes with n-doped wells and capping layers and III-N transistors, as well as any other IC components. In some embodiments, the wafer 2000 or the die 2002 may implement an ESD protection device, an RF FE device, a memory device (e.g., a static random-access memory (SRAM) device), a logic device (e.g., an AND, OR, NAND, or NOR gate), or any other suitable circuit element. Multiple ones of these devices may be combined on a single die 2002.

FIG. 10 is a side, cross-sectional view of an example IC package 2200 that may include one or more IC devices having one or more BHRs, according to some embodiments of the disclosure. In some embodiments, the IC package 2200 may be a system-in-package (SiP).

As shown in FIG. 10, the IC package 2200 may include a package substrate 2252. The package substrate 2252 may be formed of a dielectric material (e.g., a ceramic, a glass, a combination of organic and inorganic materials, a buildup film, an epoxy film having filler particles therein, etc., and may have embedded portions having different materials), and may have conductive pathways extending through the dielectric material between the face 2272 and the face 2274, or between different locations on the face 2272, and/or between different locations on the face 2274.

The package substrate 2252 may include conductive contacts 2263 that are coupled to conductive pathways 2262 through the package substrate 2252, allowing circuitry within the dies 2256 and/or the interposer 2257 to electrically couple to various ones of the conductive contacts 2264 (or to other devices included in the package substrate 2252, not shown).

The IC package 2200 may include an interposer 2257 coupled to the package substrate 2252 via conductive contacts 2261 of the interposer 2257, first-level interconnects 2265, and the conductive contacts 2263 of the package substrate 2252. The first-level interconnects 2265 illustrated in FIG. 10 are solder bumps, but any suitable first-level interconnects 2265 may be used. In some embodiments, no interposer 2257 may be included in the IC package 2200; instead, the dies 2256 may be coupled directly to the conductive contacts 2263 at the face 2272 by first-level interconnects 2265.

The IC package 2200 may include one or more dies 2256 coupled to the interposer 2257 via conductive contacts 2254 of the dies 2256, first-level interconnects 2258, and conductive contacts 2260 of the interposer 2257. The conductive contacts 2260 may be coupled to conductive pathways (not shown) through the interposer 2257, allowing circuitry within the dies 2256 to electrically couple to various ones of the conductive contacts 2261 (or to other devices included in the interposer 2257, not shown). The first-level interconnects 2258 illustrated in FIG. 10 are solder bumps, but any suitable first-level interconnects 2258 may be used. As used herein, a "conductive contact" may refer to a portion of electrically conductive material (e.g., metal) serving as an interface between different components; conductive contacts may be recessed in, flush with, or extending away from a surface of a component, and may take any suitable form (e.g., a conductive pad or socket).

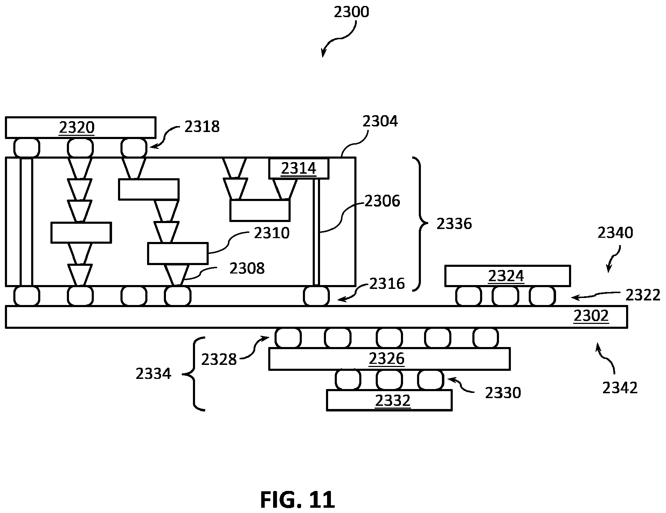

In some embodiments, an underfill material 2266 may be disposed between the package substrate 2252 and the interposer 2257 around the first-level interconnects 2265, and a mold compound 2268 may be disposed around the dies 2256 and the interposer 2257 and in contact with the package substrate 2252. In some embodiments, the underfill material 2266 may be the same as the mold compound 2268. Example materials that may be used for the underfill material 2266 and the mold compound 2268 are epoxy mold materials, as suitable. Second-level interconnects 2270 may be coupled to the conductive contacts 2264. The second-level interconnects 2270 illustrated in FIG. 10 are solder balls (e.g., for a ball grid array arrangement), but any suitable second-level interconnects 22770 may be used (e.g., pins in a pin grid array arrangement or lands in a land grid array arrangement). The second-level interconnects 2270 may be used to couple the IC package 2200 to another component, such as a circuit board (e.g., a motherboard), an interposer, or another IC package, as known in the art and as discussed below with reference to FIG. 11.

The dies 2256 may take the form of any of the embodiments of the die 2002 discussed herein and may include any of the embodiments of an IC device having one or more BHRs. In embodiments in which the IC package 2200 includes multiple dies 2256, the IC package 2200 may be referred to as a multi-chip package. Importantly, even in such embodiments of an MCP implementation of the IC package 2200, one or more BHRs may be provided in a single chip, in accordance with any of the embodiments described herein. The dies 2256 may include circuitry to perform any desired functionality. For example, one or more of the dies 2256 may be ESD protection dies, including one or more BHRs as described herein, one or more of the dies 2256 may be logic dies (e.g., silicon-based dies), one or more of the dies 2256 may be memory dies (e.g., high bandwidth memory), etc. In some embodiments, any of the dies 2256 may include one or more BHRs, e.g., as discussed above; in some embodiments, at least some of the dies 2256 may not include any III-N diodes with n-doped wells and capping layers.

The IC package 2200 illustrated in FIG. 10 may be a flip chip package, although other package architectures may be used. For example, the IC package 2200 may be a ball grid array (BGA) package, such as an embedded wafer-level ball grid array (eWLB) package. In another example, the IC package 2200 may be a wafer-level chip scale package (WLCSP) or a panel fan-out (FO) package. Although two dies 2256 are illustrated in the IC package 2200 of FIG. 10, an IC package 2200 may include any desired number of the dies 2256. An IC package 2200 may include additional passive components, such as surface-mount resistors, capacitors, and inductors disposed on the first face 2272 or the second face 2274 of the package substrate 2252, or on either face of the interposer 2257. More generally, an IC package 2200 may include any other active or passive components known in the art.

FIG. 11 is a cross-sectional side view of an IC device assembly 2300 that may include components having one or more BHRs, according to some embodiments of the disclosure. The IC device assembly 2300 includes a number of components disposed on a circuit board 2302 (which may be, e.g., a motherboard). The IC device assembly 2300 includes components disposed on a first face 2340 of the circuit board 2302 and an opposing second face 2342 of the circuit board 2302; generally, components may be disposed on one or both faces 2340 and 2342. In particular, any suitable ones of the components of the IC device assembly 2300 may include any of the IC devices implementing one or more BHRs in accordance with any of the embodiments disclosed herein; e.g., any of the IC packages discussed below with reference to the IC device assembly 2300 may take the form of any of the embodiments of the IC package 2200 discussed above with reference to FIG. 10 (e.g., may include one or more BHRs in/on a die 2256).

In some embodiments, the circuit board 2302 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 2302. In other embodiments, the circuit board 2302 may be a non-PCB substrate.

The IC device assembly 2300 illustrated in FIG. 11 includes a package-on-interposer structure 2336 coupled to the first face 2340 of the circuit board 2302 by coupling components 2316. The coupling components 2316 may electrically and mechanically couple the package-on-interposer structure 2336 to the circuit board 2302, and may include solder balls (e.g., as shown in FIG. 11), male and female portions of a socket, an adhesive, an underfill material, and/or any other suitable electrical and/or mechanical coupling structure.

The package-on-interposer structure 2336 may include an IC package 2320 coupled to an interposer 2304 by coupling components 2318. The coupling components 2318 may take any suitable form for the application, such as the forms discussed above with reference to the coupling components 2316. The IC package 2320 may be or include, for example, a die (the die 2002 of FIG. 9B), an IC device (e.g., the IC device of FIGS. 2-8), or any other suitable component. In particular, the IC package 2320 may include one or more BHRs as described herein. Although a single IC package 2320 is shown in FIG. 11, multiple IC packages may be coupled to the interposer 2304; indeed, additional interposers may be coupled to the interposer 2304. The interposer 2304 may provide an intervening substrate used to bridge the circuit board 2302 and the IC package 2320. Generally, the interposer 2304 may spread a connection to a wider pitch or reroute a connection to a different connection. For example, the interposer 2304 may couple the IC package 2320 (e.g., a die) to a BGA of the coupling components 2316 for coupling to the circuit board 2302. In the embodiment illustrated in FIG. 11, the IC package 2320 and the circuit board 2302 are attached to opposing sides of the interposer 2304; in other embodiments, the IC package 2320 and the circuit board 2302 may be attached to a same side of the interposer 2304. In some embodiments, three or more components may be interconnected by way of the interposer 2304.

The interposer 2304 may be formed of an epoxy resin, a fiberglass-reinforced epoxy resin, a ceramic material, or a polymer material such as polyimide. In some implementations, the interposer 2304 may be formed of alternate rigid or flexible materials that may include the same materials described above for use in a semiconductor substrate, such as silicon, germanium, and other group III-V and group IV materials. The interposer 2304 may include metal interconnects 2308 and vias 2310, including but not limited to through-silicon vias (TSVs) 2306. The interposer 2304 may further include embedded devices 2314, including both passive and active devices. Such devices may include, but are not limited to, capacitors, decoupling capacitors, resistors, inductors, fuses, diodes, transformers, sensors, ESD protection devices, and memory devices. More complex devices such as further RF devices, power amplifiers, power management devices, antennas, arrays, sensors, and microelectromechanical systems (MEMS) devices may also be formed on the interposer 2304. In some embodiments, the IC devices implementing one or more BHRs as described herein may also be implemented in/on the interposer 2304. The package-on-interposer structure 2336 may take the form of any of the package-on-interposer structures known in the art.

The IC device assembly 2300 may include an IC package 2324 coupled to the first face 2340 of the circuit board 2302 by coupling components 2322. The coupling components 2322 may take the form of any of the embodiments discussed above with reference to the coupling components 2316, and the IC package 2324 may take the form of any of the embodiments discussed above with reference to the IC package 2320.

The IC device assembly 2300 illustrated in FIG. 11 includes a package-on-package structure 2334 coupled to the second face 2342 of the circuit board 2302 by coupling components 2328. The package-on-package structure 2334 may include an IC package 2326 and an IC package 2332 coupled together by coupling components 2330 such that the IC package 2326 is disposed between the circuit board 2302 and the IC package 2332. The coupling components 2328 and 2330 may take the form of any of the embodiments of the coupling components 2316 discussed above, and the IC packages 2326 and 2332 may take the form of any of the embodiments of the IC package 2320 discussed above. The package-on-package structure 2334 may be configured in accordance with any of the package-on-package structures known in the art.

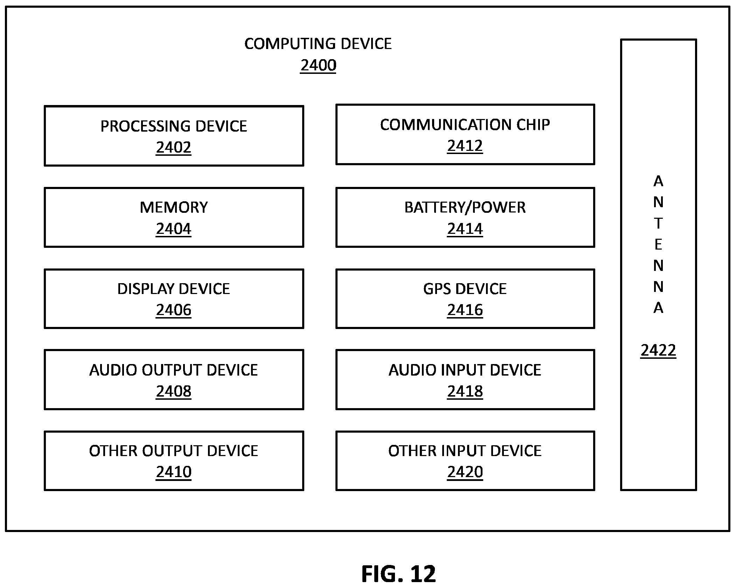

FIG. 12 is a block diagram of an example computing device 2400 that may include one or more components with one or more IC devices having one or more BHRs in accordance with any of the embodiments disclosed herein. For example, any suitable ones of the components of the computing device 2400 may include a die (e.g., the die 2002 of FIG. 9B), an IC device (e.g., the IC device of FIGS. 2-8), or any other suitable component. Any of the components of the computing device 2400 may include an IC device and/or an IC package (e.g., the IC package 2200 of FIG. 10). Any of the components of the computing device 2400 may include an IC device assembly (e.g., the IC device assembly 2300 of FIG. 11).

A number of components are illustrated in FIG. 12 as included in the computing device 2400, but any one or more of these components may be omitted or duplicated, as suitable for the application. In some embodiments, some or all of the components included in the computing device 2400 may be attached to one or more motherboards. In some embodiments, some or all of these components are fabricated onto a single SoC die.

Additionally, in various embodiments, the computing device 2400 may not include one or more of the components illustrated in FIG. 12, but the computing device 2400 may include interface circuitry for coupling to the one or more components. For example, the computing device 2400 may not include a display device 2406, but may include display device interface circuitry (e.g., a connector and driver circuitry) to which a display device 2406 may be coupled. In another set of examples, the computing device 2400 may not include an audio input device 2418 or an audio output device 2408, but may include audio input or output device interface circuitry (e.g., connectors and supporting circuitry) to which an audio input device 2418 or audio output device 2408 may be coupled.

The computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 2402 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices. The computing device 2400 may include a memory 2404, which may itself include one or more memory devices such as volatile memory (e.g., DRAM), nonvolatile memory (e.g., read-only memory (ROM)), flash memory, solid-state memory, and/or a hard drive. In some embodiments, the memory 2404 may include memory that shares a die with the processing device 2402. This memory may be used as cache memory and may include, e.g., eDRAM, and/or spin transfer torque magnetic random-access memory (STT-MRAM).

In some embodiments, the computing device 2400 may include a communication chip 2412 (e.g., one or more communication chips). For example, the communication chip 2412 may be configured for managing wireless communications for the transfer of data to and from the computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 2412 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 2412 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 2412 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 2412 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 2412 may operate in accordance with other wireless protocols in other embodiments. The computing device 2400 may include an antenna 2422 to facilitate wireless communications and/or to receive other wireless communications (such as AM or FM radio transmissions).

In some embodiments, the communication chip 2412 may manage wired communications, such as electrical, optical, or any other suitable communication protocols (e.g., the Ethernet). As noted above, the communication chip 2412 may include multiple communication chips. For instance, a first communication chip 2412 may be dedicated to shorter-range wireless communications such as Wi-Fi or Bluetooth, and a second communication chip 2412 may be dedicated to longer-range wireless communications such as global positioning system (GPS), EDGE, GPRS, CDMA, WiMAX, LTE, EV-DO, or others. In some embodiments, a first communication chip 2412 may be dedicated to wireless communications, and a second communication chip 2412 may be dedicated to wired communications.

In various embodiments, IC devices having one or more BHRs as described herein may be particularly advantageous for use as part of ESD circuits protecting power amplifiers, low-noise amplifiers, filters (including arrays of filters and filter banks), switches, or other active components. In some embodiments, IC devices having one or more BHRs as described herein may be used in PMICs, e.g., as a rectifying diode for large currents. In some embodiments, IC devices having one or more BHRs as described herein may be used in audio devices and/or in various input/output devices.

The computing device 2400 may include battery/power circuitry 2414. The battery/power circuitry 2414 may include one or more energy storage devices (e.g., batteries or capacitors) and/or circuitry for coupling components of the computing device 2400 to an energy source separate from the computing device 2400 (e.g., AC line power).

The computing device 2400 may include a display device 2406 (or corresponding interface circuitry, as discussed above). The display device 2406 may include any visual indicators, such as a heads-up display, a computer monitor, a projector, a touchscreen display, a liquid crystal display (LCD), a light-emitting diode display, or a flat panel display, for example.

The computing device 2400 may include an audio output device 2408 (or corresponding interface circuitry, as discussed above). The audio output device 2408 may include any device that generates an audible indicator, such as speakers, headsets, or earbuds, for example.

The computing device 2400 may include an audio input device 2418 (or corresponding interface circuitry, as discussed above). The audio input device 2418 may include any device that generates a signal representative of a sound, such as microphones, microphone arrays, or digital instruments (e.g., instruments having a musical instrument digital interface (MIDI) output).

The computing device 2400 may include a GPS device 2416 (or corresponding interface circuitry, as discussed above). The GPS device 2416 may be in communication with a satellite-based system and may receive a location of the computing device 2400, as known in the art.

The computing device 2400 may include an other output device 2410 (or corresponding interface circuitry, as discussed above). Examples of the other output device 2410 may include an audio codec, a video codec, a printer, a wired or wireless transmitter for providing information to other devices, or an additional storage device.

The computing device 2400 may include an other input device 2420 (or corresponding interface circuitry, as discussed above). Examples of the other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 2400 may be any other electronic device that processes data.

Example 1 provides an IC device, including: a first semiconductor structure and a second semiconductor structure of one or more transistors; a layer including an electrically conductive material, the layer coupled to the first semiconductor structure and the second semiconductor structure; a plate including a thermally conductive material; and a rail coupled to the layer by a via and coupled to the plate by a through-substrate via, where the rail is between the first and second semiconductor structures and the plate.

Example 2 provides the IC device according to example 1, further including a support structure including a semiconductor material and at least partially adjoining the plate, where the through-substrate via and the rail are in the support structure.

Example 3 provides the IC device according to example 2, where a portion of the plate adjoins the support structure, and another portion of the plate does not adjoin the support structure.

Example 4 provides the IC device according to any of the preceding claims, where a surface of the through-substrate via adjoins a surface of the rail, and the surface of the through-substrate via has a larger area than the surface of the rail.

Example 5 provides the IC device according to any of the preceding claims, where: the rail is a power rail that is coupled to the first semiconductor structure and the second semiconductor structure; the plate includes a first section and a second section; the first section is electrically insulated from the second section; and the rail is coupled to the first section of the plate by the through-substrate via.

Example 6 provides the IC device according to example 5, where the rail is a first rail, the via is a first via, and the through-substrate via is a first through-substrate via, further including: a third and a fourth semiconductor structures coupled to the layer; and a second rail coupled to the second section of the plate by a second through-substrate via and coupled to the layer by a second via, where the second rail is between the third and fourth semiconductor structures.

Example 7 provides the IC device according to any of the preceding claims, where: the first semiconductor structure and the second semiconductor structure are in a first cell of the IC device; at least a portion of the plate is in a second cell of the IC device; and the second cell is adjacent to the first cell.

Example 8 provides the IC device according to example 8, where the second cell is a filler cell.

Example 9 provides the IC device according to any of the preceding claims, where the first semiconductor structure and the second semiconductor structure are in a same cell of the IC device as the plate.

Example 10 provides the IC device according to any of the preceding claims, where the layer is a first layer and the electrically conductive material is a first electrically conductive material, further including a second layer including a second electrically conductive material, where the first layer is between the second layer and the rail.

Example 11 provides an IC device, including: a plurality of semiconductor structures of one or more transistors; a layer including an electrically conductive material, the layer coupled to the plurality of semiconductor structures; a plate including a thermally conductive material; and a plurality of rails coupled to the plate by a plurality of through-substrate vias, individual ones of the rails present between two adjacent semiconductor structures of the plurality of semiconductor structures.

Example 12 provides the IC device according to example 11, further including a support structure between the layer and the plate, the support structure including a semiconductor material of the plurality of semiconductor structures.

Example 13 provides the IC device according to example 12, where the plurality of through-substrate vias and the plurality of the rails are in the support structure.

Example 14 provides the IC device according to any one of examples 11-13, where a rail of the plurality of rails is coupled to the layer by a via.

Example 15 provides the IC device according to any one of examples 11-14, where the rail is between the via and the plurality of through-substrate vias.

Example 16 provides the IC device according to any one of examples 11-15, where: the plate includes a plurality of sections that are electrically insulated from each other; and the individual ones of the plurality of rails connected to individual ones of the plurality of sections of the plate.

Example 17 provides the IC device according to any one of examples 11-16, where a surface of a through-substrate via of the plurality of through-substrate vias adjoins a surface of a rail of the plurality of rails, and the surface of the through-substrate via has a larger area than the surface of the rail.

Example 18 provides an IC device, including: a first cell including: a transistor, at least a portion of a layer, the layer including an electrically conductive material, and a first portion of a rail, where the portion of the layer is coupled to the transistor; and a second cell including: at least a portion of a plate, the plate including a thermally conductive material, a through-substrate via, and a second portion of the rail, where the rail is coupled to the plate by the through-substrate via, the rail is coupled to the layer by a via, and the first cell is adjacent to the second cell.

Example 19 provides the IC device according to example 18, where the rail and through-substrate via are buried in a support structure, the support structure includes a semiconductor material, and the via is outside the support structure.

Example 20 provides the IC device according to example 19, where a first portion of the plate adjoins the support structure and a second portion of the plate does not adjoin the support structure.

Example 21 provides a n integrated circuit (IC) package, including the IC device according to any of the proceeding examples; and a further IC component, coupled to the IC device.

Example 22 provides the IC package according to example 21, where the further IC component includes one of a package substrate, an interposer, or a further IC die.

Example 23 provides the IC package according to example 21 or 22, where the IC device according to any one of examples 1-20 may include, or be a part of, at least one of a memory device, a computing device, a wearable device, a handheld electronic device, and a wireless communications device.

Example 24 provides a n electronic device, including a carrier substrate; and one or more of the IC devices according to any one of examples 1-20 and the IC package according to any one of examples 21-23, coupled to the carrier substrate.

Example 25 provides the electronic device according to example 24, where the carrier substrate is a motherboard.

Example 26 provides the electronic device according to example 24, where the carrier substrate is a PCB.

Example 27 provides the electronic device according to any one of examples 24-26, where the electronic device is a wearable electronic device or handheld electronic device.

Example 28 provides the electronic device according to any one of examples 24-27, where the electronic device further includes one or more communication chips and an antenna.

Example 29 provides the electronic device according to any one of examples 24-28, where the electronic device is an RF transceiver.

Example 30 provides the electronic device according to any one of examples 24-28, where the electronic device is one of a switch, a power amplifier, a low-noise amplifier, a filter, a filter bank, a duplexer, an upconverter, or a downconverter of an RF communications device, e.g., of an RF transceiver.

Example 31 provides the electronic device according to any one of examples 24-30, where the electronic device is a computing device.

Example 32 provides the electronic device according to any one of examples 24-31, where the electronic device is included in a base station of a wireless communication system.

Example 33 provides the electronic device according to any one of examples 24-31, where the electronic device is included in a user equipment device of a wireless communication system.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) device, comprising:
a first semiconductor structure and a second semiconductor structure of one or more transistors;
a layer comprising an electrically conductive material, the layer coupled to the first semiconductor structure and the second semiconductor structure;
a plate comprising a thermally conductive material; and
a rail coupled to the layer by a via and coupled to the plate by a through-substrate via,
wherein the rail is between the first and second semiconductor structures and the plate.

2. The IC device according to claim 1, further comprising:
a support structure comprising a semiconductor material and at least partially adjoining the plate, wherein the through-substrate via and the rail are in the support structure.

3. The IC device according to claim 1 or 2, wherein a surface of the through-substrate via adjoins a surface of the rail, and the surface of the through-substrate via has a larger area than the surface of the rail.

4. The IC device according to any of the preceding claims, wherein:
the rail is a power rail that is coupled to the first semiconductor structure and the second semiconductor structure;
the plate comprises a first section and a second section;
the first section is electrically insulated from the second section; and
the rail is coupled to the first section of the plate by the through-substrate via.

5. The IC device according to any of the preceding claims, wherein:
the first semiconductor structure and the second semiconductor structure are in a first cell of the IC device;
at least a portion of the plate is in a second cell of the IC device; and
the second cell is adjacent to the first cell.

6. The IC device according to any of the preceding claims, wherein the first semiconductor structure and the second semiconductor structure are in a same cell of the IC device as the plate.

7. The IC device according to any of the preceding claims, wherein the layer is a first layer and the electrically conductive material is a first electrically conductive material, further comprising a second layer comprising a second electrically conductive material, wherein the first layer is between the second layer and the rail.

8. An integrated circuit (IC) device, comprising:
a plurality of semiconductor structures of one or more transistors;
a layer comprising an electrically conductive material, the layer coupled to the plurality of semiconductor structures;
a plate comprising a thermally conductive material; and
a plurality of rails coupled to the plate by a plurality of through-substrate vias, individual ones of the rails present between two adjacent semiconductor structures of the plurality of semiconductor structures.

9. The IC device according to claim 8, further comprising a support structure between the layer and the plate, the support structure comprising a semiconductor material of the plurality of semiconductor structures.

10. The IC device according to claim 8 or 9, wherein a rail of the plurality of rails is coupled to the layer by a via, or the rail is between the via and the plurality of through-substrate vias.

11. The IC device according to any one of claims 8-10, wherein:
the plate comprises a plurality of sections that are electrically insulated from each other; and
the individual ones of the plurality of rails connected to individual ones of the plurality of sections of the plate.

12. The IC device according to any one of claims 8-11, wherein a surface of a through-substrate via of the plurality of through-substrate vias adjoins a surface of a rail of the plurality of rails, and the surface of the through-substrate via has a larger area than the surface of the rail.

13. An integrated circuit (IC) device, comprising:
a first cell comprising:
a transistor,
at least a portion of a layer, the layer comprising an electrically conductive material, and
a first portion of a rail, wherein the portion of the layer is coupled to the transistor; and
a second cell comprising:
at least a portion of a plate, the plate comprising a thermally conductive material,
a through-substrate via, and
a second portion of the rail,
wherein the rail is coupled to the plate by the through-substrate via, the rail is coupled to the layer by a via, and the first cell is adjacent to the second cell.

14. The IC device according to claim 13, wherein the rail and through-substrate via are buried in a support structure, the support structure comprises a semiconductor material, and the via is outside the support structure.

15. The IC device according to claim 14, wherein a first portion of the plate adjoins the support structure and a second portion of the plate does not adjoin the support structure.
